# EUROPEAN PATENT SPECIFICATION

(11) **EP 4 467 951 B1**
(45) Date of publication and mention of the grant of the patent: **10.12.2025**
(21) Application number: 24177856.2
(22) Date of filing: 24.05.2024
(51) Int. Cl.: G01L 9/00, G01L 19/00, G01L 23/12

(54) **CAPACITIVE MEMS PRESSURE TRANSDUCER AND RELATED MANUFACTURING PROCESS**
KAPAZITIVER MEMS-DRUCKWANDLER UND ZUGEHÖRIGES HERSTELLUNGSVERFAHREN
TRANSDUCTEUR DE PRESSION MEMS CAPACITIF ET PROCÉDÉ DE FABRICATION ASSOCIÉ

(30) Priority: 26.05.2023 IT 202300010716
(43) Date of publication of application: 27.11.2024
(73) Proprietor: STMicroelectronics International N.V., 1228 Plan-les-Ouates, Geneva (CH)
(72) Inventor: NICOLI, Silvia, 20836 BRIOSCO (MB) (IT); ALLEGATO, Giorgio, 20900 MONZA (IT); DANIELE, Filippo, 20149 MILANO (IT); NOMELLINI, Andrea, 20159 MILANO (IT); TURI, Maria Carolina, 20148 MILANO (IT)
(74) Representative: Studio Torta S.p.A.

(56) References cited:
- WO-A1-2019/138004
- US-A1- 2011 031 567
- US-A1- 2023 064 114
- US-B2- 11 248 976

## Description

### Technical Field

The present invention relates to a capacitive microelectromechanical (MEMS) pressure transducer and to the related manufacturing process.

### Background

As is known, numerous MEMS pressure transducers of capacitive type are currently available, which provide for forming a capacitor including an electrode formed by a membrane, which delimits a cavity and deforms as a function of pressure; in this manner, pressure variations are transduced into capacitance variations, which may be detected electronically.

For example, US 8,344,466 describes a manufacturing process of a MEMS transducer, wherein the cavity is formed by forming openings which traverse the membrane and face a dielectric region, the successive closure of these openings being obtained through deposition of a porous silicon layer; successively, part of the dielectric region is removed by etch with a chemical agent flowing through the porous silicon layer, resulting in the formation of the cavity and release of the membrane, which is then completed by depositing a further polysilicon layer.

The solution according to US 8,344,466 may be formed starting from a single wafer, however the area of the electrode formed by the membrane depends on the aforementioned chemical etch, therefore it is not very controllable.

WO 2019/1380004 A1 discloses a transducer according to the preamble of claim 1.

US 11,248,976 B2 discloses a capacitive pressure sensor including a membrane suspended over a cavity and electrically conductive anchor trenches laterally surrounding the cavity.

US 2011/031567 A1 discloses a process for manufacturing a MEMS device, wherein: a membrane region of semiconductor material is epitaxially grown on the sacrificial region; through apertures are formed in the membrane region; the side wall and the bottom of the apertures are coated with a porous material layer; at least one portion of the sacrificial region is selectively removed through the porous material layer, to form a cavity; and the apertures are filled with filling material so as to form a monolithic membrane suspended above the cavity.

US 2023/064114 A1 discloses a method for manufacturing a micro-electro-mechanical device, which includes the steps of: forming, on a substrate, a first protection layer of crystallized aluminum oxide, impermeable to HF; forming, on the first protection layer, a sacrificial layer of silicon oxide removable with HF; forming, on the sacrificial layer, a second protection layer of crystallized aluminum oxide; exposing a sacrificial portion of the sacrificial layer; forming, on the sacrificial portion, a first membrane layer of a porous material, permeable to HF; forming a cavity by removing the sacrificial portion through the first membrane layer; and sealing pores of the first membrane layer by forming a second membrane layer on the first membrane layer.

The aim of the present invention is therefore to provide a capacitive MEMS pressure transducer which overcomes at least in part the drawbacks of the prior art.

### Summary

According to the present invention a capacitive MEMS pressure transducer and a manufacturing process are provided, as defined in the attached claims.

### Brief Description of the Figures

For a better understanding of the present invention, embodiments thereof are now described, purely by way of nonlimiting example, with reference to the attached drawings, wherein:
- Figure 1 schematically shows a cross-section of a MEMS transducer;
- Figure 2 schematically shows a top-view with portions removed of a part of the MEMS transducer shown in Figure 1;
- Figure 3 schematically shows a cross-section (taken along section line III-III shown in Figure 4) with portions removed of a part of the MEMS transducer shown in Figures 1 and 2;
- Figure 4 schematically shows a top-view with portions removed of a part of the MEMS transducer shown in Figures 1 and 2;
   - Figure 5 schematically shows a cross-section of a variant of the MEMS transducer;
   - Figure 6 schematically shows a top-view with portions removed of a part of the MEMS transducer shown in Figure 5;
   - Figures 7 and 9 schematically show cross-sections of variants of the MEMS transducer;
   - Figure 8 schematically shows a top-view with portions removed of a part of the MEMS transducer shown in Figure 7;
   - Figures 10-26 schematically show cross-sections of a MEMS transducer, during successive steps of a manufacturing process.

### Description of Embodiments

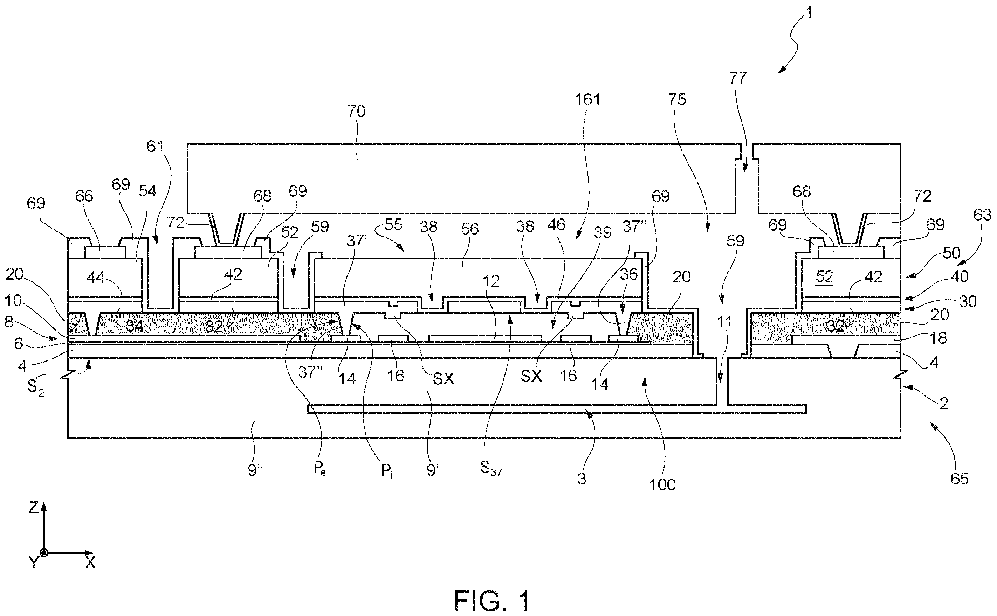

Figure 1 shows a MEMS pressure transducer 1 of capacitive type, hereinafter referred to as the MEMS transducer 1, and an orthogonal reference system XYZ.

The MEMS transducer 1 comprises a semiconductor body 2, which is upwardly delimited by a front surface S₂, parallel to the plane XY. A buried cavity 3 extends inside the semiconductor body 2, at a distance from the front surface S₂. Furthermore, a lower portion of a trench 11 extends through part of the semiconductor body 2, starting from the front surface S₂, so as to communicate downwardly with the buried cavity 3 and laterally delimit a portion 9' of the semiconductor body 2, which delimits the buried cavity 3 upwardly, and which is hereinafter referred to as the suspended portion 9' of the semiconductor body 2. In greater detail, the suspended portion 9' of the semiconductor body 2 extends cantilever, above the buried cavity 3, starting from a fixed portion 9" of the semiconductor body 2.

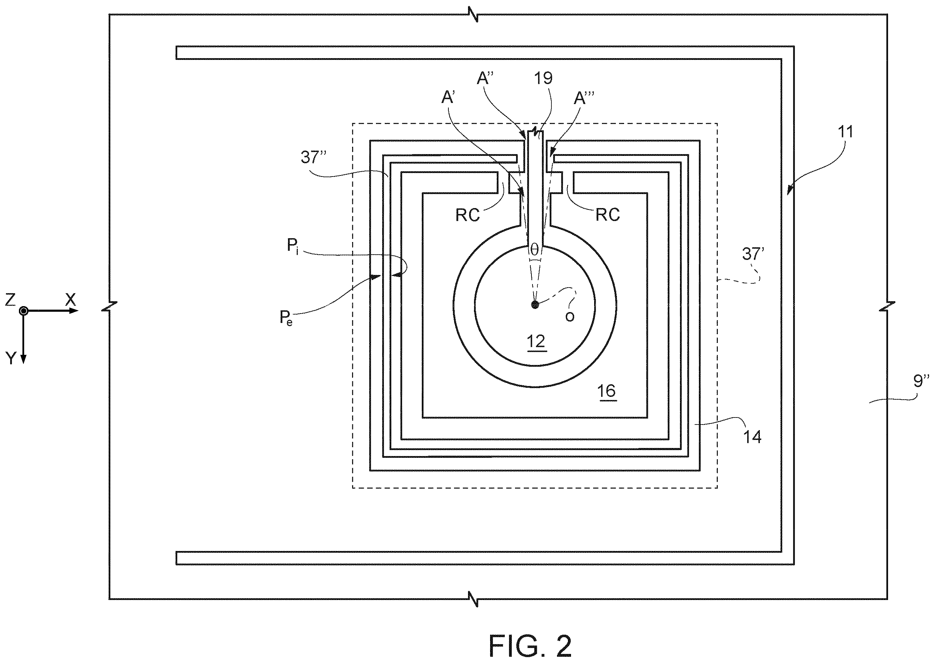

Purely by way of example, the trench 11 may have a 'C' shape, in top-view, as shown in Figure 2, wherein the trench 11 is shown in a simplified manner with respect to what has been shown in Figure 1.

The MEMS transducer 1 further comprises a lower dielectric region 4, which extends above the front surface S₂, in direct contact with the semiconductor body 2, and is formed, for example, by thermal oxide. In particular, part of the lower dielectric region 4 covers the fixed portion 9" of the semiconductor body 2. Furthermore, part of the lower dielectric region 4 extends over the suspended portion 9' of the semiconductor body 2.

The MEMS transducer 1 further comprises a stopping region 6, which extends on the lower dielectric region 4 and may be formed, for example, by aluminum oxide (Al₂O₃).

In greater detail, part of the stopping region 6 partially covers the part of the lower dielectric region 4 which covers the fixed portion 9" of the semiconductor body 2. Furthermore, part of the stopping region 6 extends on the part of the lower dielectric region 4 that overlies the suspended portion 9' of the semiconductor body 2. In addition, and without any loss of generality, the stopping region 6 does not entirely cover the lower dielectric region 4, but leaves exposed a part of the lower dielectric region 4.

The MEMS transducer 1 further comprises a lower conductive structure 8 of polysilicon, which comprises a routing region 10, which, without any loss of generality, extends on a portion of the stopping region 6 that overlies, at a distance, the fixed portion 9" of the semiconductor body 2.

The lower conductive structure 8 further comprises a lower electrode region 12, a lower anchoring region 14 and a covering region 16, which are therefore formed by polysilicon, extend on the part of the stopping region 6 which overlies, at a distance, the suspended portion 9' of the semiconductor body 2 and are coplanar with each other and with the routing region 10. Furthermore, the lower electrode region 12, the lower anchoring region 14 and the covering region 16 are laterally separated from each other. Furthermore, the lower conductive structure 8 comprises a pair of connection regions RC (visible in Figure 2).

The lower conductive structure 8 also comprises a ground contact region 18, which extends on the part of the lower dielectric region 4 left exposed by the stopping region 6 and, without any loss of generality, is laterally offset with respect to the buried cavity 3; furthermore, the ground contact region 18 is separated from the routing region 10, the lower electrode region 12, the lower anchoring region 14, the covering region 16 and the connection regions RC and extends in part through the lower dielectric region 4, so as to contact, downwardly, the fixed portion 9" of the semiconductor body 2.

In greater detail, the lower electrode region 12, the lower anchoring region 14, the covering region 16 and the connection regions RC overlie, at a distance, the buried cavity 3. Furthermore, as shown qualitatively in Figure 2, wherein the lower electrode region 12 has been assumed to have an approximately circular shape in top-view, the covering region 16 has an approximately 'C' shape and laterally surrounds the lower electrode region 12; in particular, without any loss of generality, the covering region 16 surrounds the lower electrode region 12 entirely, except for a first opening A', which is precisely laterally delimited by the covering region 16.

Again without any loss of generality, the lower anchoring region 14 has an elongated shape, approximately a 'C' shape (in top-view) and laterally surrounds the covering region 16. In particular, the lower anchoring region 14 surrounds the covering region 16 entirely, except for a second opening A", which is precisely laterally delimited by the lower anchoring region 14. Furthermore, both the first and the second openings A', A" are delimited downwardly by corresponding exposed portions of the stopping region 6.

The lower conductive structure 8 further comprises a contact region 19 (visible in Figure 2), which is coplanar with the lower electrode region 12, the lower anchoring region 14, the covering region 16 and the connection regions RC. The contact region 19 extends through the first and the second openings A', A" and is interposed, in direct contact, between the lower electrode region 12 and the routing region 10 (not shown in Figure 2). Furthermore, purely by way of example, and without any loss of generality, the connection regions RC extend on opposite sides of a portion of the contact region 19, in a symmetrical manner and parallel to the axis Y, in such a way that each connection region RC has ends integral with the lower anchoring region 14 and the covering region 16, respectively. In this manner, the lower anchoring region 14, the covering region 16 and the connection regions RC form a single region, which laterally surrounds, at a distance, the lower electrode region 12.

The MEMS transducer 1 further comprises an upper dielectric region 20, which is formed for example by TEOS oxide and extends above the routing region 10, the ground contact region 18, as well as above an outer portion of the lower anchoring region 14, described below. As qualitatively visible in Figure 1, the upper dielectric region 20 also extends on the part of the lower dielectric region 4 left exposed by the stopping region 6 and on the portions of the stopping region 6 which extend into the space separating the outer portion of the lower anchoring region 14 from the routing region 10. In this regard, an upper portion of the trench 11 extends through the part of the upper dielectric region 20 which extends on the part of the lower dielectric region 4 left exposed by the stopping region 6 and laterally offset with respect to the ground contact region 18.

The MEMS transducer 1 further comprises a first, a second and a third upper conductive structure 30, 40, 50, which are formed by polysilicon and have approximately a same shape, in top-view.

In detail, the first upper conductive structure 30 comprises a respective annular region 32, which in top-view has an annular shape and extends above portions of the upper dielectric region 20, in direct contact. In particular, without any loss of generality, the annular region 32 of the first upper conductive structure 30 extends above portions of the upper dielectric region 20 that overlie the routing region 10 and above portions of the upper dielectric region 20 that overlie the ground contact region 18. Although not shown, part of the annular region 32 traverses the upper dielectric region 20, so as to contact the ground contact region 18. Also, although not shown, in top-view the annular region 32 surrounds the trench 11, so as to overlie, at a distance, the fixed portion 9" of the semiconductor body 2.

The first upper conductive structure 30 further comprises a respective peripheral region 34, which extends on a portion of the upper dielectric region 20 that overlies the routing region 10, outside the annular region 32; furthermore, the peripheral region 34 also extends through the upper dielectric region 20, so as to contact the underlying routing region 10.

The first upper conductive structure 30 further comprises an inner region 36, hereinafter referred to as the first inner region 36.

The first inner region 36 comprises a suspended portion 37' and an anchoring portion 37", which form a single monolithic polysilicon region.

In particular, as visible in Figure 2 (wherein the position of the perimeter of the suspended portion 37' is shown schematically in dotted lines), the anchoring portion 37" has an elongated shape, approximately a 'C' shape, in top-view; furthermore, the anchoring portion 37" is arranged above the lower anchoring region 14, wherewith it is in direct contact, and laterally delimits a cavity 39, hereinafter referred to as the sensing cavity 39.

In greater detail, in top-view, the anchoring portion 37" has a width (in the plane XY, along the perimeter of the respective elongated shape) that is smaller with respect to the width of the lower anchoring region 14 and is arranged with respect to the latter so as to leave exposed an inner portion of the lower anchoring region 14, which faces the sensing cavity 39, and furthermore so as to be laterally offset with respect to the aforementioned outer portion of the lower anchoring region 14, which, as mentioned, is overlaid by the upper dielectric region 20 (not shown in Figure 2).

In practice, the anchoring portion 37" is delimited by outer lateral walls Pₑ (only one indicated in Figure 2) and by inner lateral walls Pᵢ (only one indicated in Figure 2); the inner lateral walls Pᵢ face the sensing cavity 39, while the outer lateral walls Pₑ contact the upper dielectric region 20.

The suspended portion 37' extends above the anchoring portion 37", so as to delimit the sensing cavity 39 upwardly, which is delimited downwardly by the inner portion of the lower anchoring region 14, the lower electrode region 12, the covering region 16, the connection regions RC, a part of the contact region 19 and portions of the stopping region 6 arranged below the suspended portion 37' and left exposed by the lower electrode region 12, the lower anchoring region 14, the covering region 16, the connection regions RC and the contact region 19.

The suspended portion 37' is traversed by a plurality of holes 38 (two visible in Figure 1) of through type, which face the sensing cavity 39 downwardly. Furthermore, without any loss of generality, the suspended portion 37' extends laterally so as to protrude in part outside the anchoring portion 37", in top-view. The part of suspended portion 37' which protrudes externally with respect to the underlying anchoring portion 37" overlies a corresponding portion of the upper dielectric region 20, in direct contact.

Again without any loss of generality, in the example shown in Figure 1, the suspended portion 37' is delimited downwardly by a flat surface S₃₇, which, in rest conditions, is parallel to the plane XY; furthermore, the suspended portion 37' forms protection structures SX (optional), which depart from the flat surface S₃₇ in the direction of the lower conductive structure 8, for reasons which will be clarified below.

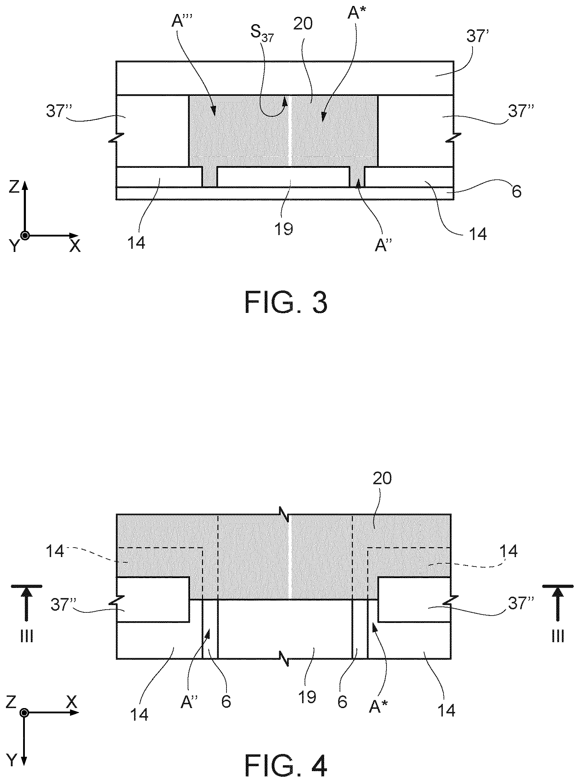

In greater detail, as also visible in Figure 3, the anchoring portion 37" laterally delimits a third opening A‴, which is upwardly delimited by the suspended portion 37' and communicates downwardly with the second opening A", wherewith it forms a lateral opening A* of the sensing cavity 39. The lateral opening A* faces a corresponding portion of the upper dielectric region 20, which laterally closes the lateral opening A*, in such a way that the sensing cavity 39 is hermetically closed, with an internal pressure which may for example be comprised between 1µbar and 1bar; furthermore, as visible in the example of Figure 4, part of the upper dielectric region 20 may partially penetrate into the lateral opening A* of the sensing cavity 39, while not penetrating inside the sensing cavity 39. However, variants are possible (not shown) wherein the upper dielectric region 20 does not penetrate inside the lateral opening A*, while continuing to close it laterally.

The second upper conductive structure 40 comprises a respective annular region 42, which overlies the annular region 32 of the first upper conductive structure 30, in direct contact. In top-view, the annular region 42 may have approximately the same shape as the annular region 32.

The second upper conductive structure 40 further comprises a respective peripheral portion 44, which extends above the peripheral portion 34 of the first upper conductive structure 30. In top-view, the peripheral portion 44 may have approximately the same shape as the peripheral portion 34.

The second upper conductive structure 40 also comprises a second inner region 46, which is layered and extends on the first inner region 36 and inside the holes 38, for example in a conformal manner, therefore without completely filling the holes 38, but coating the related lateral walls and the respective bottoms. The portions of the second inner region 46 which extend on the bottom of the holes 38 therefore face the sensing cavity 39.

The third upper conductive structure 50 comprises a respective annular region 52, which overlies the annular region 42 of the second upper conductive structure 40, in direct contact. In top-view, the annular region 52 may have approximately the same shape as the annular region 42.

The third upper conductive structure 50 further comprises a respective peripheral portion 54, which extends on the peripheral portion 44 of the second upper conductive structure 40. In top-view, the peripheral portion 54 may have approximately the same shape as the peripheral portion 44.

The third upper conductive structure 50 further comprises a third inner region 56, which extends on the second inner region 46 and comprises portions which extend inside the holes 38, to fill them. In other words, in each hole 38 a corresponding portion of the third inner region 56 is present, which is coated laterally and downwardly by a corresponding portion of the second inner region 46.

As mentioned, the first, the second and the third inner regions 36, 46, 56 have approximately a same shape, in top-view. Furthermore, the part of the suspended portion 37' which overlies the sensing cavity 39 and the overlying portions of the second and the third inner regions 46, 56 form a membrane 55 of polysilicon, which has a thickness for example comprised between 1µm and 6um, functions as the upper electrode of a variable detection capacitor and faces the underlying lower electrode region 12, which functions as a fixed lower electrode of the detection capacitor. Furthermore, since, while being manufactured, as described below, at different times, the first, the second and the third inner regions 36, 46, 56 are formed by polysilicon, as a first approximation no lattice discontinuities occur between the first, the second and the third inner regions 36, 46, 56.

In addition, the first, the second and the third upper conductive structures 30, 40, 50 are patterned in such a way that the membrane 55 is laterally separated, by a trench 59, from the annular regions 32, 42, 52; hereinafter reference is made to the upper trench 59 to indicate the trench 59. Furthermore, the peripheral portions 34, 44, 54 are separated from the annular regions 32, 42, 52 by an opening 61, which faces the upper dielectric region 20.

In practice, the first, the second and the third upper conductive structures 30, 40, 50 form a conductive body 63, which forms, together with the semiconductor body 2, the lower dielectric region 4, the stopping region 6 and the lower conductive structure 8, a main body 65. Furthermore, the conductive body 63 is traversed by the opening 61 and by the upper trench 59; furthermore, a part of the upper trench 59 faces the upper dielectric region 20, while another part of the upper trench 59 faces the underlying upper portion of the trench 11, wherewith it is in fluidic communication.

The MEMS transducer 1 further comprises a plurality of pads 66 of conductive material (for example, aluminum, copper or gold). In Figure 1 only one pad 66 is visible, which overlies the peripheral portion 54 of the third upper conductive structure 50, in direct contact; thereby, the pad 66 is in electrical contact with the routing region 10, and therefore also with the lower electrode region 12. In use, the pad 66 is therefore set to the same potential as the lower electrode region 12. Although not shown, and purely by way of example, a further pad is electrically connected to the lower anchoring region 14, so as to be set to the same potential as the membrane 55; in use, a voltage equal to the voltage present between the membrane 55 and the lower electrode region 12 is present between this pad and the pad 66.

The MEMS transducer 1 further comprises a conductive coupling region 68, which is formed for example by metal material (for example, copper, aluminum or gold), has an annular shape and extends above the annular region 52 of the third upper conductive structure 50, in direct contact. Furthermore, although not visible in Figure 1, the conductive coupling region 68 is electrically connected (for example) to the ground contact region 18, so as to be set to the same potential as the semiconductor body 2.

The main body 6 also comprises a passivation region 69, which is formed for example by silicon nitride (SiN) or nitride oxide and extends over the upper conductive structure 50, in direct contact, leaving exposed the pads 66 and the conductive coupling region 68. Furthermore, optionally, the passivation region 69 may leave exposed the third inner region 56, so as to reduce the mechanical stresses to which the membrane 55 is subject.

In addition, in the example shown in Figure 1, the passivation region 69 coats the lateral walls of the opening 61, as well as the lateral walls of the upper trench 59; in addition, the passivation region 69 coats the portions of the upper dielectric region 20 which form the bottom of the upper trench 59 and the lateral walls of the upper portion of the trench 11.

In greater detail, the passivation region 69 coats upwardly the portions of the upper dielectric region 20 left exposed by the conductive body 63 and also laterally coats the portions of the lower dielectric region 4 and of the upper dielectric region 20 that face the trench 11, so as to form a protective structure which prevents any humidity present around the membrane 55 from penetrating inside the portions of the upper dielectric region 20 that surround the anchoring portion 37" and inside the portions of the lower dielectric region 4 that are arranged below the sensing cavity 39; in this manner it is avoided that, following the absorption of humidity by these portions of the lower dielectric region 4 and of the upper dielectric region 20, mechanical stresses are generated which entail an undesired deformation of the sensing cavity 39, which causes a drift of the response of the MEMS transducer 1.

In other words, referring to the dielectric support structure 100 to indicate the portions of the lower dielectric region 4 and of the upper dielectric region 20 laterally delimited by the upper portion of the trench 11 and arranged above the suspended portion 9' of the semiconductor body 2, the first, the second and the third inner regions 36, 46, 56 extend above part of the dielectric support structure 100. The dielectric support structure 100 is laterally coated by the passivation region 69, except for the part of the dielectric support structure 100 which is integral with portions of the lower dielectric region 4 and of the upper dielectric region 20 which overlie the fixed portion 9" of the semiconductor body 2. The sensing cavity 39 extends inside the dielectric support structure 100. Furthermore, the passivation region 69 coats upwardly the portions of the dielectric support structure 100 left exposed by the first, the second and the third inner regions 36, 46, 56.

The MEMS transducer 1 also comprises a cap 70 formed by semiconductor material, which is coupled to the conductive body 63 so as to form an accommodation chamber 75, having the membrane 55 extending therewithin. The sensing cavity 39 does not fluidically communicate with the accommodation chamber 75, i.e. it is fluidically insulated from the latter.

In detail, the cap 70 is mechanically coupled to the conductive coupling region 68 by interposing a bonding region 72, which is formed, for example, by an aluminum and germanium (AlGe) alloy and is in fact interposed, in direct contact, between the conductive coupling region 68 and a corresponding portion of the cap 70. In particular, the cap 70 overlies the membrane 55 and the upper trench 59. Instead, without any loss of generality, the cap 70 is laterally offset with respect to the pads 66, to facilitate the formation of related electrical connections with an external circuitry (not shown).

In greater detail, the accommodation chamber 75 comprises the upper trench 59 and communicates, thanks to the trench 11, with the buried cavity 3. Furthermore, the cap 70 is traversed by a respective hole 77, which places the accommodation chamber 75 in fluidic communication with the outside world.

In use, the accommodation chamber 75 and the buried cavity 3 are set to the same pressure present outside the MEMS transducer 1. Consequently, the membrane 55 is subject to a deformation which depends on the pressure difference present between the sensing cavity 39 and the outside world. The capacitance of the detection capacitor therefore varies as a function of the pressure present outside the MEMS transducer 1; therefore, a pressure capacitive transduction occurs. In particular, the capacitance variations, and therefore the value of the external pressure, may be detected in a per se known manner on the basis of the electric voltage present between the membrane 55 and the lower electrode region 12. This detection may be performed by an external electronic circuit (not shown), which is coupled to the pads 66. Furthermore, the protection structures SX are for reducing the contact area between the membrane 55 and the set formed by the lower electrode region 12 and by the covering region 16, so as to avoid bonding phenomena in the case of excessive pressure. To this end, the protection structures SX are at the same potential as the lower anchoring region 14, the covering region 16 and the connection regions RC.

This having been said, the MEMS transducer 1 is characterized in that the shape of the membrane 55 (and therefore of the upper electrode of the detection capacitor) is defined by the anchoring portion 37", except for the possible uncertainty as to the extent of the penetration of the upper dielectric region 20 into the lateral opening A*. In other words, unlike what occurs in the prior art, wherein the dimensions of the membrane are defined by controlling the parameters of an etching process, in the present case the dimensions of the membrane 55 are more controllable, which results in an improvement in the accuracy of the pressure detection. Furthermore, since the anchoring portion 37" of the first inner region 36 contacts with the underlying lower anchoring region 14 (therefore, they are at the same potential), only the lower electrode region 12 causes a fixed capacitance contribution, having an effective increase in the sensitivity value of the MEMS transducer 1 not corresponding thereto.

As to the presence of the covering region 16, it allows the area of the stopping region 6 left exposed to be reduced, resulting in the reduction of the probability that defectivenesses occur. Furthermore, the membrane 55 has no dielectric portions, which would entail the presence, inside the membrane 55, of regions having coefficients of thermal expansion that are very different from each other, resulting in the generation of unwanted mechanical stresses.

As to the buried cavity 3, it allows the mechanical stress induced by the package (not shown) of the MEMS transducer 1 on the fixed portion 9" of the semiconductor body 2 to be decoupled from the membrane 55 and from the suspended portion 9', in such a way that, as a first approximation, this mechanical stress does not affect the pressure measurement. In any case, the presence of the buried cavity 3 is optional; embodiments (not shown) are therefore possible wherein the buried cavity 3 and the lower portion of the trench 11 are absent.

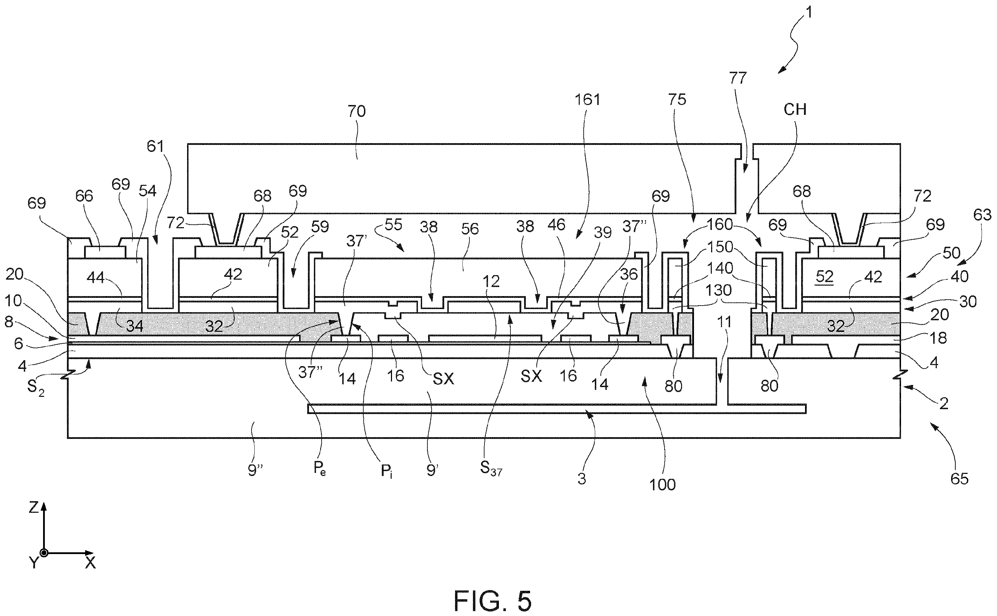

Figure 5 shows an embodiment which differs from what has been shown in Figure 1 for the following reasons.

In detail, the lower conductive structure 8 comprises a lower barrier structure 80, which is formed by polysilicon and extends in part on the part of the lower dielectric region 4 left exposed by the stopping region 6 and in part through the lower dielectric region 4, so as to contact, downwardly, the suspended portion 9" of the semiconductor body 2. Furthermore, without any loss of generality, the lower barrier structure 80 is separated from the lower anchoring region 14 and from the ground contact region 18.

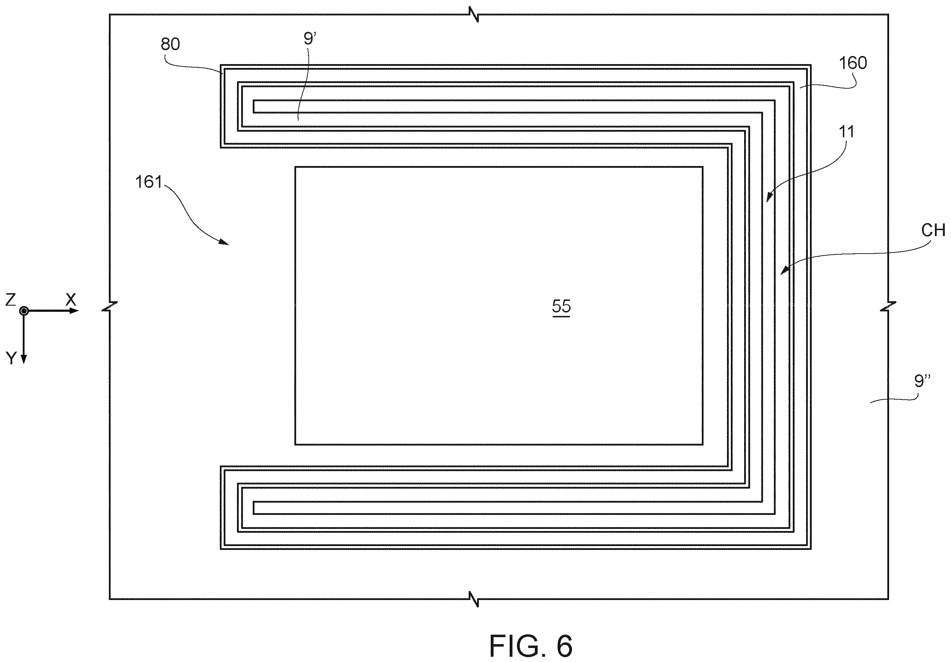

In greater detail, as visible in Figure 6 (wherein, for the sake of simplicity, inter alia, the lower dielectric region 4 and the upper dielectric region 20 are not shown), the lower barrier structure 80 has a closed elongated shape (therefore, in top-view forms a ring-shaped region) and extends so as to laterally surround, at a distance, the upper portion of the trench 11. Consequently, in top-view, the upper portion of the trench 11 extends inside the lower barrier structure 80.

The first, the second and the third upper conductive structures 30, 40, 50 comprise respective barrier regions, indicated by 130, 140, 150 respectively, which are formed by polysilicon and form an upper barrier structure 160. As a first approximation, the barrier regions 130, 140, 150 have a same shape in top-view.

In greater detail, the barrier region 130 of the first upper conductive structure 30 extends in part on the upper dielectric region 20 and in part through the upper dielectric region 20, so as to contact the underlying lower barrier structure 80.

The barrier region 140 of the second upper conductive structure 140 overlies the barrier region 130 of the first upper conductive structure 30; the barrier region 150 of the third upper conductive structure 50 overlies the barrier region 140 of the second upper conductive structure 140.

In practice, the upper barrier structure 160 is laterally offset with respect to the first, the second and the third inner regions 36, 46, 56 and overlies, in direct contact, the lower barrier structure 80. Furthermore, as visible in Figure 6, the upper barrier structure 160 has a closed elongated shape, therefore in top-view it has a ring shape, and laterally delimits a channel CH, which in top-view is arranged inside the upper barrier structure 160 and overlies the underlying upper portion of the trench 11, wherewith it communicates. Furthermore, as still visible in Figure 6, the first, the second and the third inner regions 36, 46, 56 are arranged outside the upper barrier structure 160, which extends in part above the suspended portion 9' of the semiconductor body 2 and in part above the fixed portion 9" of the semiconductor body 2. Furthermore, the passivation region 69 coats the upper barrier structure 160 laterally and upwardly, therefore it laterally coats the walls of the channel CH and the portion of upper dielectric region 20 left exposed by the first, the second and the third inner regions 36, 46, 56 and the barrier structure 160.

The passivation region 69 does not penetrate inside the trench 11, to the advantage of the constructive simplicity of the MEMS transducer 1. In fact, the upper barrier structure 160 and the lower barrier structure 80 form a barrier which is impenetrable by humidity and laterally delimits an accommodation space 161, having the membrane 55 and the sensing cavity 39 extending therewithin.

In particular, the lower barrier structure 80 and the barrier region 130 laterally surround a portion of the dielectric support structure 100 which surrounds the sensing cavity 39 laterally and downwardly. More particularly, the first, the second and the third inner regions 36, 46, 56 extend above part of this portion of the dielectric support structure 100, having the sensing cavity 39 extending therewithin. Even more particularly, this portion of the dielectric support structure 100 is surrounded by the lower barrier structure 80 and the barrier region 130, except for a respective part which is integral with portions of the lower dielectric region 4 and of the upper dielectric region 20 that overlie the fixed portion 9" of the semiconductor body 2. Furthermore, the parts of this portion of the dielectric support structure 100 left exposed by the first, the second and the third inner regions 36, 46, 56 and by the upper barrier structure 160 are coated upwardly by the passivation region 69. In this manner, the upper barrier structure 160 is laterally spaced from the membrane 55, improving the protection of the latter against humidity.

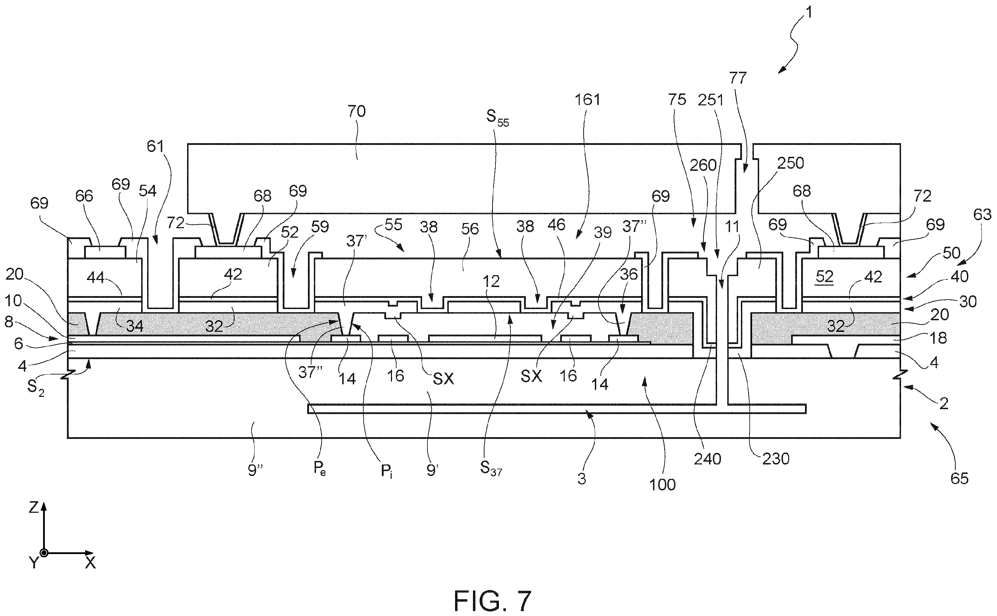

Figure 7 shows a further variant, which differs from what has been shown in Figure 5 for the following reasons.

In detail, the upper barrier structure (here indicated by 260) is again formed by the barrier regions (respectively indicated by 230, 240, 250) of the first, the second and the third upper conductive structures 30, 40, 50 and is laterally spaced from the first, the second and the third inner regions 36, 46, 56; furthermore, the upper barrier structure 260 extends in part on the upper dielectric region 20 and in part through the upper dielectric region 20 and the lower dielectric region 4, so that the barrier region 230 contacts the front surface S₂. The lower barrier structure 80 is absent.

The upper portion of the trench 11 extends through the barrier regions 230, 240, 250 of the first, the second and the third upper conductive structures 30, 40, 50, while the lower portion of the trench 11 still extends through part of the semiconductor body 2.

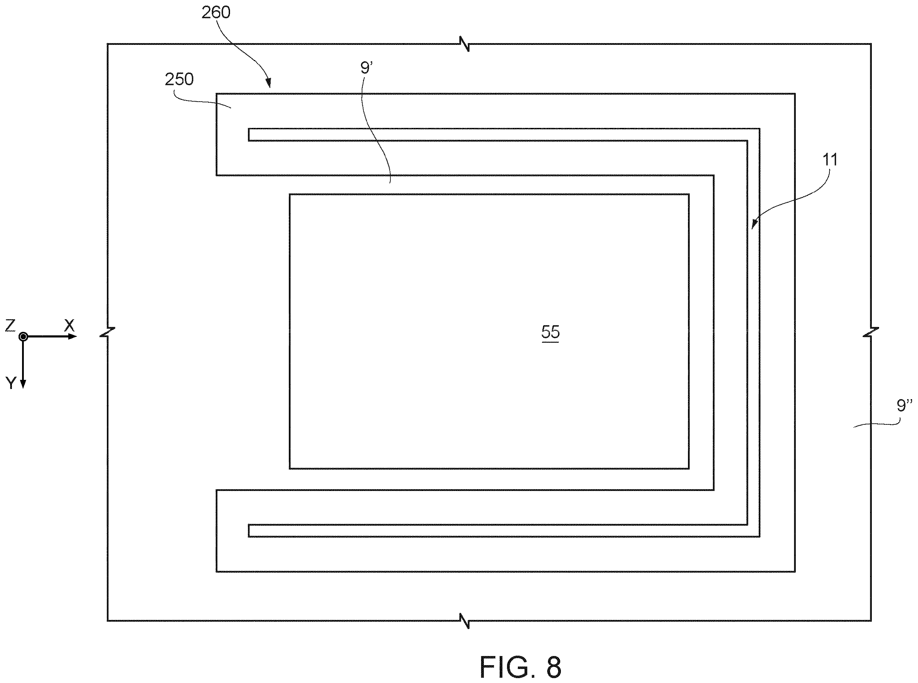

As shown qualitatively in Figure 8, the trench 11 still has a 'C' shape, in top-view; furthermore, the upper portion of the trench 11 is entirely delimited, laterally, by the upper barrier structure 260, which, without any loss of generality, is laterally coated by the passivation region 69.

Again by way of example, the passivation region 69 leaves exposed a portion of the barrier region 250 of the third upper conductive structure 50 traversed by the trench 11. Referring to the upper conductive surface S₅₅ to indicate the upper surface of the third inner region 56 and of the barrier region 250, the aforementioned exposed portion of the barrier region 250 delimits a recess 251 which extends, starting from the upper conductive surface S₅₅, downwards, where it communicates with the underlying trench 11.

In practice, the MEMS transducer 1 is characterized by a certain constructive simplicity, in particular as to the trench 11, which may be formed by performing a single etch. Furthermore, since the upper barrier structure 260 extends downwardly up to contacting the semiconductor body 2, and also laterally surrounds part of the dielectric support structure 100, it functions as a barrier against humidity, together with the portions of the passivation region 69 which coat the portions of the dielectric support structure 100 left exposed by the first, the second and the third inner regions 36, 46, 56 and the upper barrier structure 260.

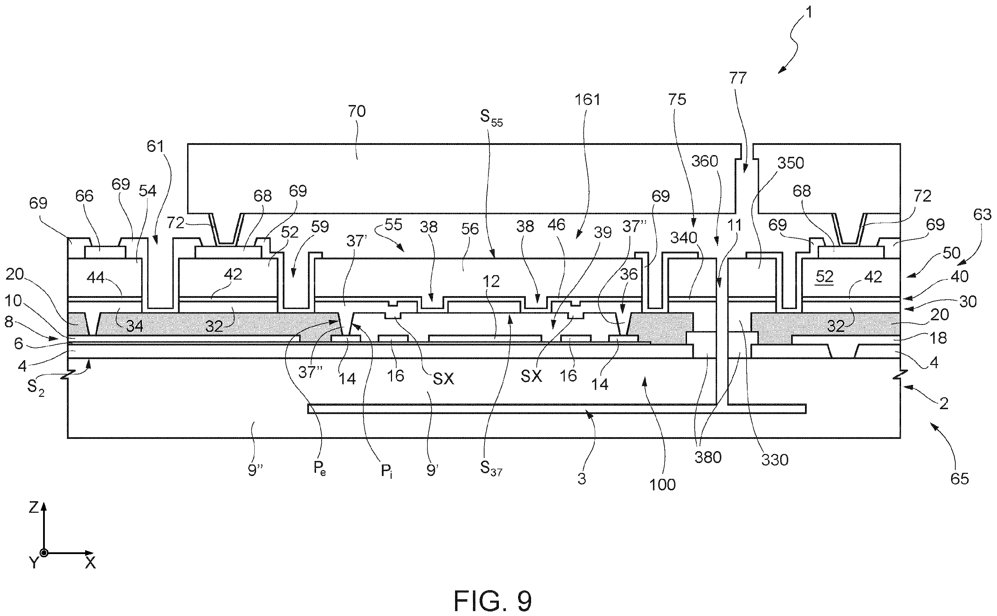

Figure 9 shows a further variant, which differs from what has been shown in Figure 7 for the following reasons.

The lower barrier structure (here indicated by 380) is present and extends in part on the part of the lower dielectric region 4 left exposed by the stopping region 6 and in part through the lower dielectric region 4, so as to contact, downwardly, the semiconductor body 2. The upper barrier structure (here indicated by 360) is again formed by the barrier regions (respectively indicated by 330, 340, 350) of the first, the second and the third upper conductive structures 30, 40, 50. The barrier region 330 of the first upper conductive structure 30 extends in part on the upper dielectric region 20 and in part through the upper dielectric region 20, so as to contact the underlying lower barrier structure 380.

The barrier region 350 of the third upper conductive structure 50 faces the upper membrane surface S₅₅. Furthermore, the upper portion of the trench 11 extends, starting from the upper membrane surface S₅₅, through the upper barrier structure 360 and through the lower barrier structure 380.

The embodiment shown in Figure 9 is characterized, with respect to what has been shown in Figure 7, in that the upper barrier structure 360 may be manufactured in a further simplified manner, since the lithographic mask used to form the trench 11 may be arranged at the same height as the upper membrane surface S₅₅, thanks to the absence of the recess 251.

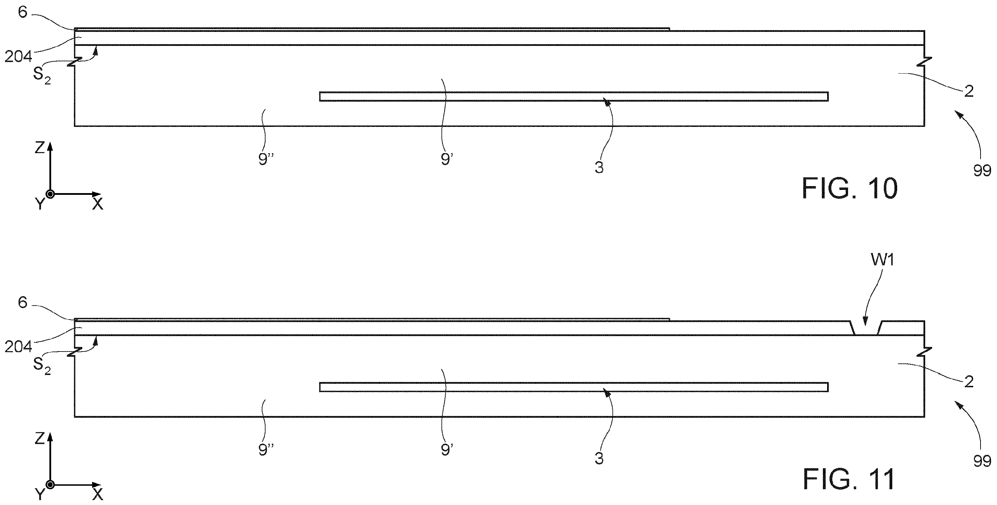

Steps of a manufacturing process of the MEMS transducer 1 shown in Figure 1 are described hereinbelow, starting from a first semiconductive wafer 99 comprising the semiconductor body 2, wherein, in a per se known manner, the buried cavity 3 has been formed, as shown in Figure 10. Furthermore, a lower dielectric layer 204, which is formed by thermal oxide and is intended to form the lower dielectric region 4, is present on the front surface S₂ of the semiconductor body 2. The stopping region 6 is arranged on a portion of the lower dielectric layer 204.

This having been said, subsequently, as shown in Figure 11, a portion of the lower dielectric layer 204 is removed, so as to form a first process opening W1, which faces the front surface S₂ and is intended to be occupied by the ground contact region 18.

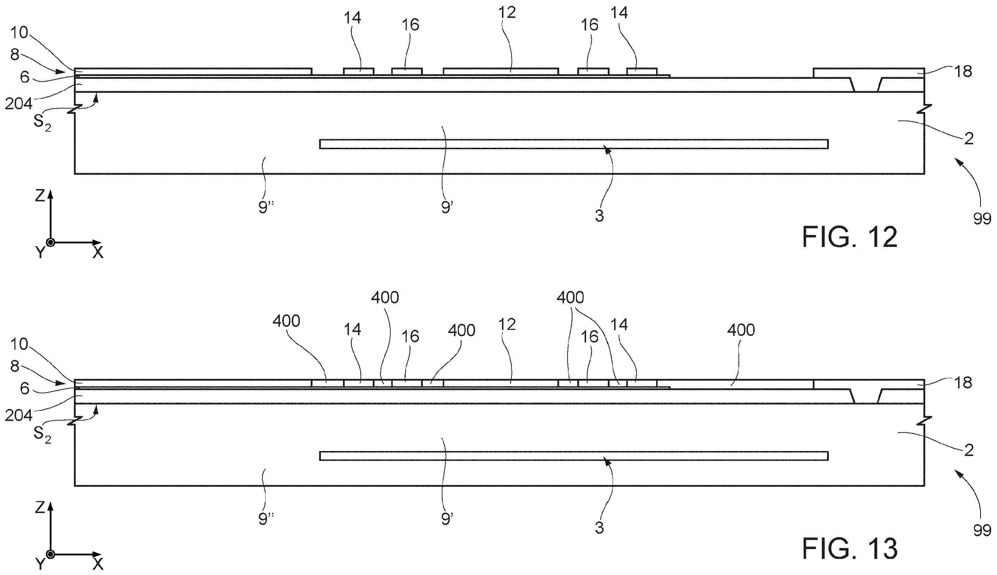

Subsequently, as shown in Figure 12, the lower conductive structure 8 is formed, for example by performing a Low Pressure Chemical Vapor Deposition (LPCVD) of a polysilicon layer having a thickness comprised, for example, between 300nm and 1000nm and a successive etch.

Successively, as shown in Figure 13, a filling region 400 of oxide is formed on the portions of the stopping region 6 and the lower dielectric layer 204 left exposed by the lower conductive structure 8. To this end, although not shown in detail, a Plasma Enhanced Chemical Vapor Deposition (PECVD) of TEOS oxide may be performed, possibly followed by a planarization step.

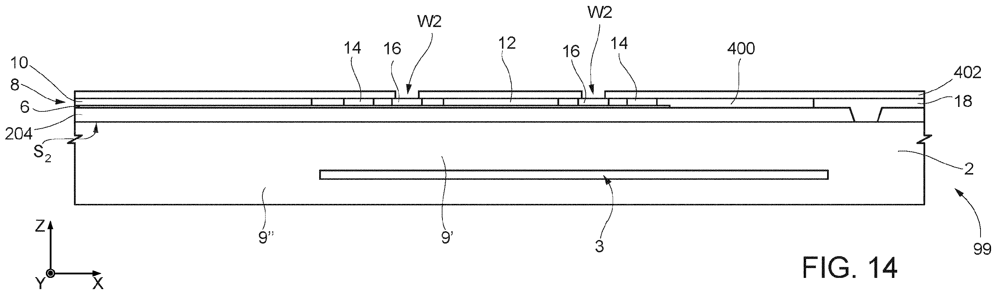

Subsequently, as shown in Figure 14, an intermediate dielectric layer 402 of TEOS oxide is formed with a thickness for example comprised between 250nm and 500nm, for example by LPCVD or PECVD deposition; furthermore, portions of the intermediate dielectric layer 402 are selectively removed, so as to form second process openings W2, which face the covering region 16.

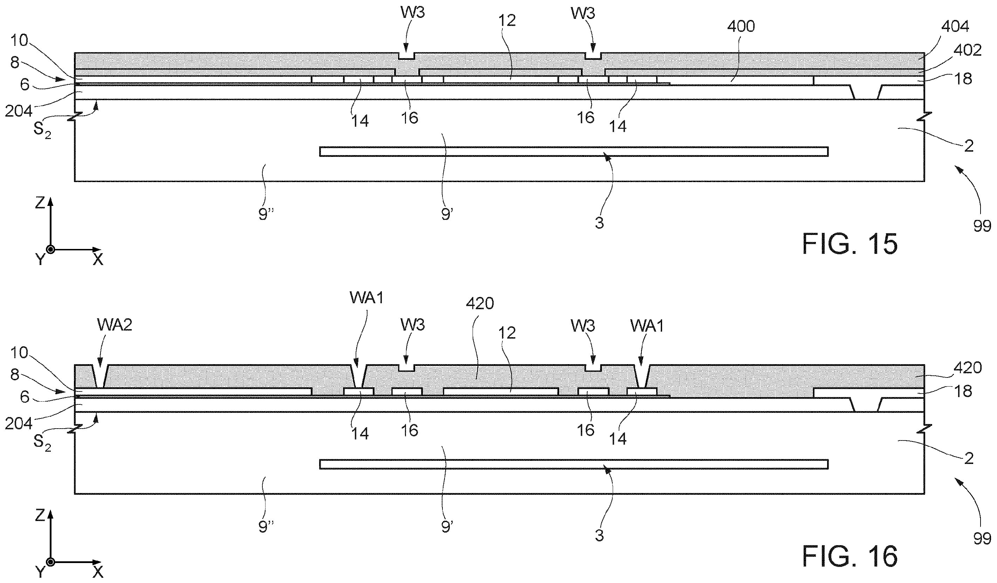

Successively, as shown in Figure 15, an upper dielectric layer 404 of TEOS oxide with a thickness for example comprised between 250nm and 500nm is formed on the intermediate dielectric layer 402, for example by LPCVD or PECVD deposition. The upper dielectric layer 404 fills the second process openings W2; consequently, the upper dielectric layer 404 has third process openings W3.

In practice, the filling region 400, the intermediate dielectric layer 402 and the upper dielectric layer 404 are formed by a same material and form a single dielectric region, which is referred to as the front dielectric layer 420 (shown in Figure 16); therefore, the sole front dielectric layer 420 will be indicated in the following Figures. The front dielectric layer 420 is intended to form the upper dielectric region 20.

Subsequently, as shown in Figure 16, portions of the front dielectric layer 420 are selectively removed (for example, by dry etch), so as to form a main anchoring window WA1 and a secondary anchoring window WA2, which traverse the front dielectric layer 420 and face the lower anchoring region 14 and the routing region 10, respectively.

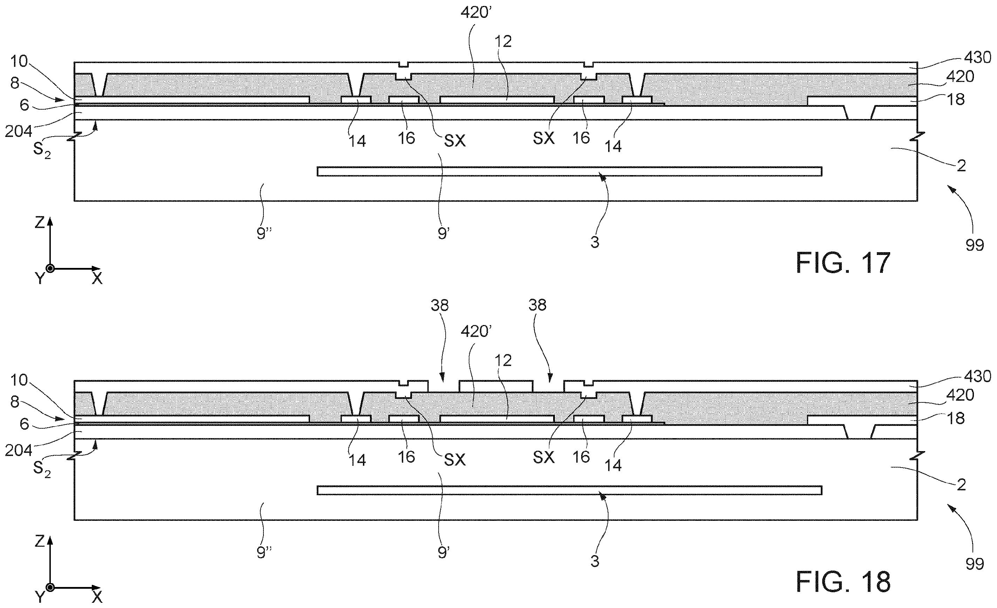

Subsequently, as shown in Figure 17, a polysilicon layer, referred to as the first conductive layer 430, is formed on the front dielectric layer 420. For example, the first conductive layer 430 is formed by LPCVD deposition, has a thickness comprised between 200nm and 500nm and is impermeable to gases. The first conductive layer 430 fills the main anchoring window WA1 and the secondary anchoring window WA2. Furthermore, the first conductive layer 430 fills the third process openings W3; the portions of the first conductive layer 430 which fill the third process openings W3 form the protection structures SX.

In the following, reference is made to the sacrificial region 420' to indicate the portion of the front dielectric layer 420 which is laterally delimited by the portion of the first conductive layer 430 which extends into the main anchoring window WA1, which is intended to form the anchoring portion 37" of the first inner region 36. A portion of the first conductive layer 430, which is intended to form the suspended portion 37' of the first inner region 36, extends on the sacrificial region 420'. In addition, the sacrificial region 420' overlies the lower electrode region 12, the covering region 16, the inner portion of the lower anchoring region 14 and the connection regions RC (not visible in Figure 17).

Subsequently, as shown in Figure 18, portions of the first conductive layer 430 are selectively removed, so as to form the holes 38, which face the sacrificial region 420'. To this end, a dry etch is for example performed.

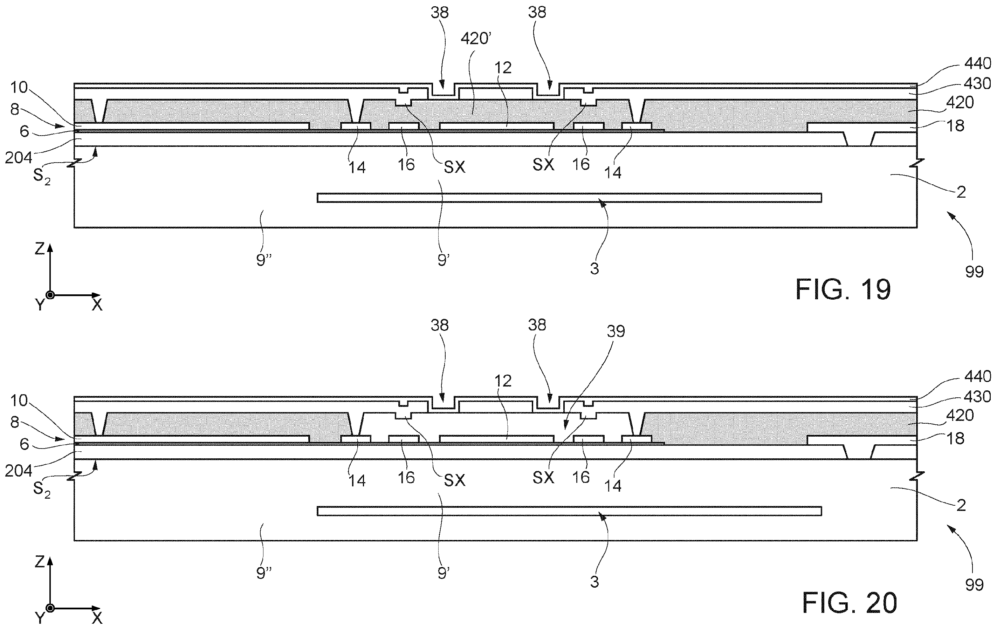

Successively, as shown in Figure 19, a second conductive layer 440, of polysilicon permeable to gases, is deposited on the first conductive layer 430. The second conductive layer 440 has a thickness comprised for example between 100nm and 300nm (for example, approximately equal to 120nm). Furthermore, the second conductive layer 440 coats the lateral walls and the bottom of the holes 38 in a conformal manner, i.e. without filling them. The portions of sacrificial region 420' which form the bottoms of the holes 38 are then coated with corresponding portions of the second conductive layer 440, in direct contact.

Successively, as shown in Figure 20, gaseous hydrofluoric acid (HF) is flown through the holes 38, therefore through the portions of second conductive layer 440 which coat the bottoms of the holes 38. In this manner, the sacrificial region 420' is removed. The sensing cavity 39 is thus formed.

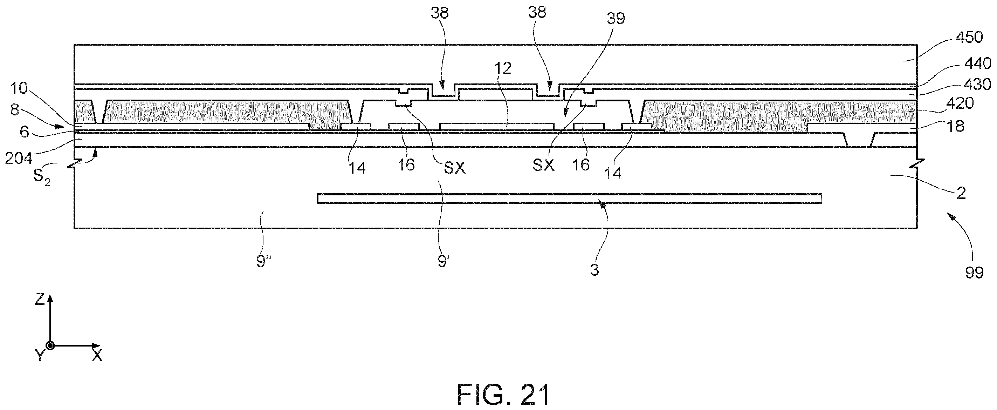

Subsequently, as shown in Figure 21, a third conductive layer 450 of polysilicon, impermeable to gases, is formed on the second conductive layer 440. The third conductive layer 450 fills the holes 38, so as to hermetically close them, i.e. so as to prevent the gas from flowing through the holes 38.

In particular, in order to prevent the polysilicon from penetrating the sensing cavity 39, creating unwanted contacts with the lower electrode region 12, the third conductive layer 450 may be formed by performing an epitaxial growth of polysilicon (for example, at ambient pressure).

Subsequently, although not shown, an annealing may be performed in a nitrogen environment, to create a vacuum in the sensing cavity 39 or in any case to set the pressure value in the sensing cavity 39.

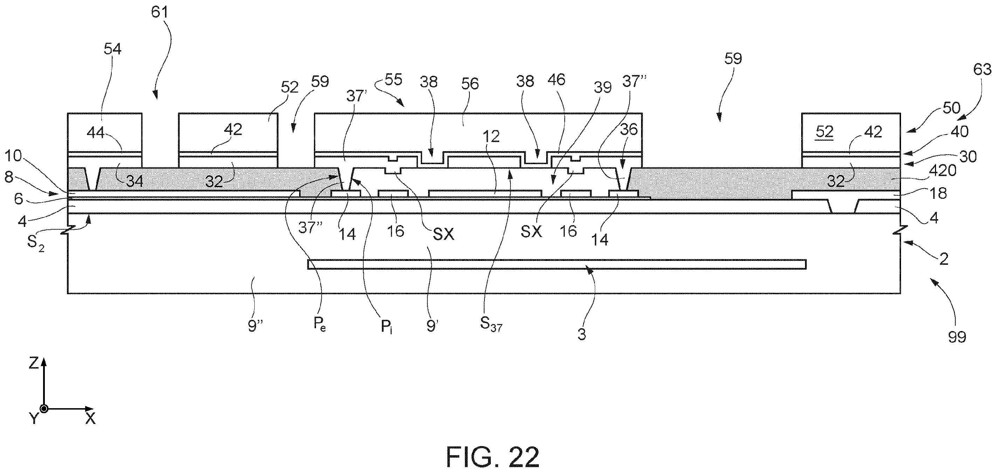

Successively, as shown in Figure 22, portions of the first, the second and the third conductive layers 430, 440, 450 are selectively removed, for example by performing a dry etch, in such a way that the remaining portions of the first, the second and the third conductive layers 430, 440, 450 form the first, the second and the third upper conductive structures 30, 40, 50, respectively.

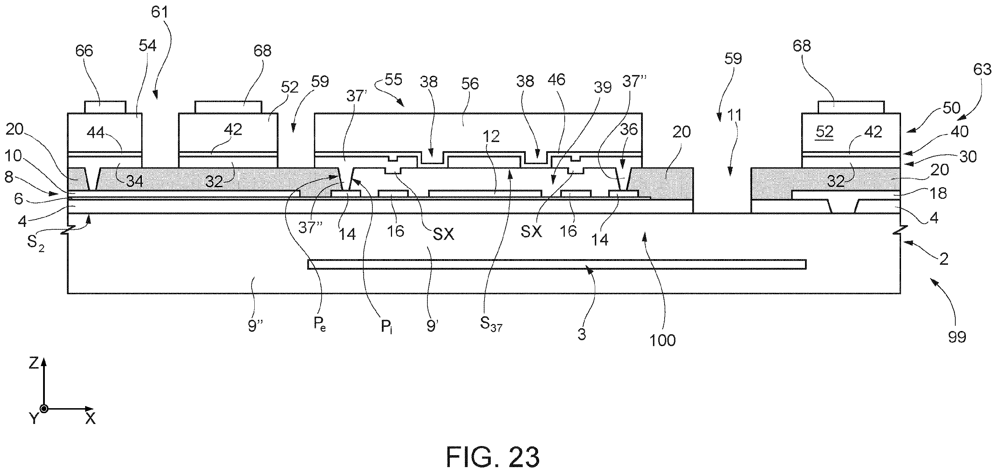

Subsequently, as shown in Figure 23, the pads 66 and the conductive coupling region 68 may be formed, for example by a deposition of metal material and a successive patterning; furthermore, as shown again in Figure 23, portions of the front dielectric layer 420 and underlying portions of the lower dielectric layer 204 are selectively removed, for example by a dry etch, so as to form the upper portion of the trench 11, which exposes a portion of the front surface S₂. The remaining portions of the lower dielectric layer 204 and the front dielectric layer 420 form the lower dielectric region 4 and the upper dielectric region 20, respectively.

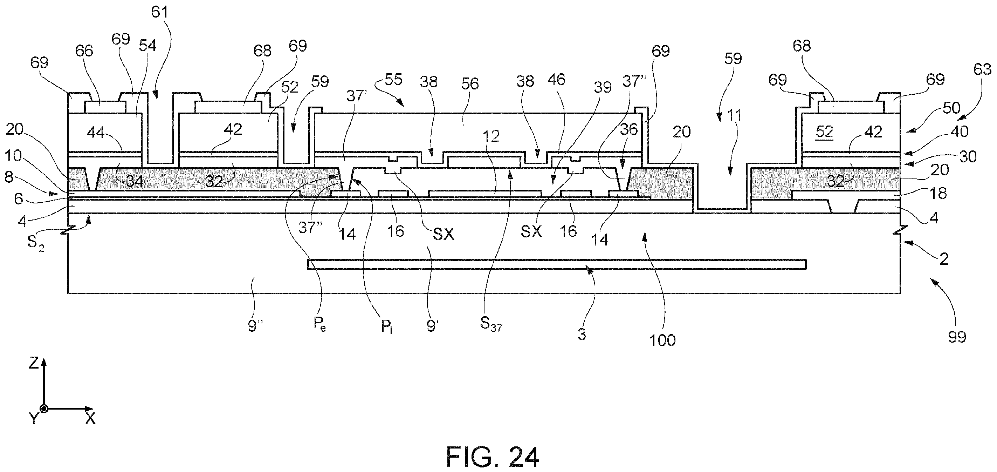

Subsequently, as shown in Figure 24, the passivation region 69 is formed, for example by a deposition of silicon nitride. Although not shown in detail, initially the passivation region 69 may also coat the pads 66, the conductive coupling region 68 and the third inner region 56 of the membrane 55; successively, portions of the passivation region 69 are selectively removed, so as to expose the pads 66, the conductive coupling region 68 and the third inner region 56 of the membrane 55. Furthermore, as visible in Figure 24, the passivation region 69 coats the lateral walls and the bottom of the upper portion of the trench 11.

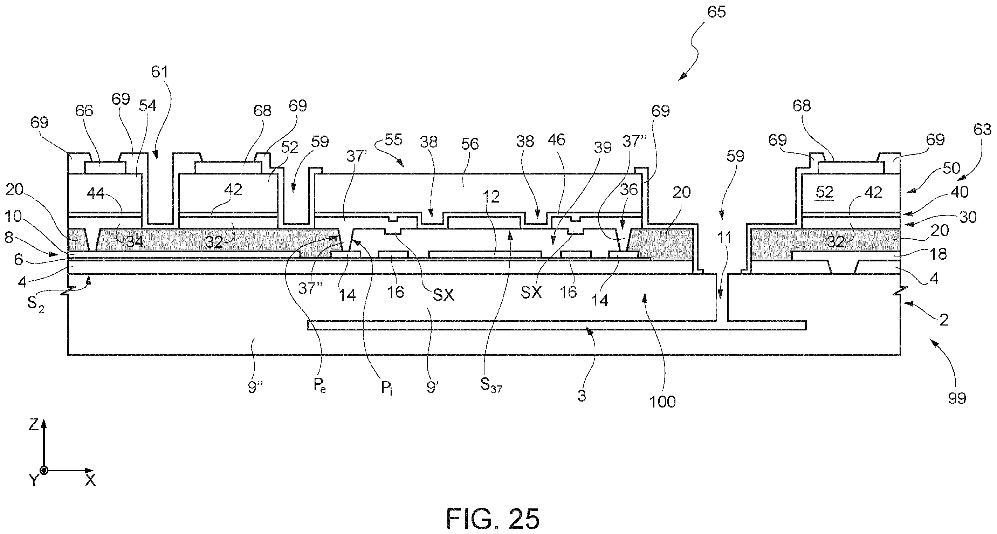

Subsequently, as shown in Figure 25, a portion of the passivation region 69 which coats the bottom of the upper portion of the trench 11 is selectively removed, so as to expose an underlying portion of the semiconductor body 2; subsequently, as shown again in Figure 25, a part of the exposed portion of the semiconductor body 2 is selectively removed, so as to form the bottom portion of the trench 11, which communicates with the buried cavity 3, and release the suspended portion 9' of the semiconductor body 2. The main body 65 is thus formed.

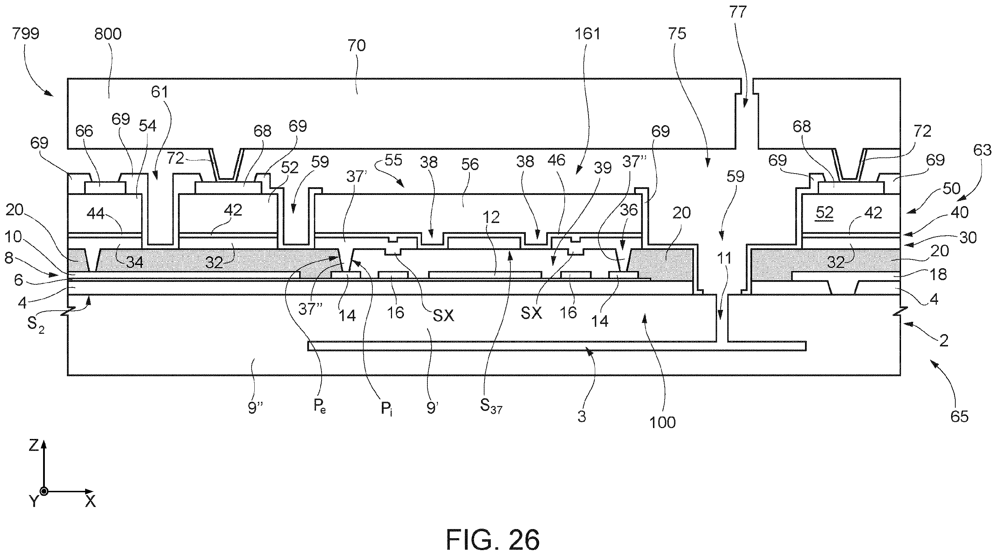

Subsequently, as shown in Figure 26, the first wafer 99 is mechanically coupled to a second wafer 799 which forms the cap 70. In particular, the coupling occurs by the bonding region 72. Furthermore, the second wafer 799 comprises a semiconductive portion 800 which overlies, at a distance, the pads 66, which is successively removed (operation not shown), so as to form the MEMS transducer 1 shown in Figure 1. Subsequently, the manufacturing process proceeds in a per se known manner, for example by performing dicing operations (not shown) .

Although not shown in detail, the variants of Figures 5, 7 and 9 may be manufactured with the same manufacturing process previously described, in particular as to forming the membrane 55 and the sensing cavity 39, and with resulting variations relating to the patterning of the passivation region 69.

In greater detail, as to forming the lower barrier structure 80 (if any), it may be formed in the same manner as the ground contact region 18. As to the upper barrier structure 160, it is formed in the same manner described with reference to the first, the second and the third inner regions 36, 46, 56, and simultaneously therewith; consequently, forming the upper barrier structure 160 provides for forming a corresponding anchoring window through the front dielectric layer 420, which faces the lower barrier structure 80, before forming the first, the second and the third conductive layers 430, 440, 450.

In the case of the upper barrier structure 260 shown in Figure 7, it may be formed, for example, by performing the operations of selectively removing portions of the front dielectric layer 420 and of underlying portions of the lower dielectric layer 204 shown in Figure 23 before forming the first, the second and the third conductive layers 430, 440, 450 and the patterning thereof.

In the case of the upper barrier structure 360 shown in Figure 9, it may be formed, for example, by forming the lower barrier structure 380 in the same manner and simultaneously with the ground contact region 18; successively, the upper barrier structure 360 is formed in the same manner described with reference to the first, the second and the third inner regions 36, 46, 56, and simultaneously therewith. Consequently, forming the upper barrier structure 360 may provide for forming a corresponding anchoring window through the front dielectric layer 420, which faces the lower barrier structure 380, before forming the first, the second and the third conductive layers 430, 440, 450. The trench 11 is then formed by performing a single etch through the upper barrier structure 360 and the lower barrier structure 380.

The advantages which the present solution affords are clear from the preceding description.

In particular, according to the present solution, the lateral extension of the sensing cavity 39, and therefore also the shape of the membrane 55, substantially does not depend on the parameters of an etching process, little controllable, but is defined by the shape of the anchoring portion 37". Furthermore, the membrane 55 is formed by a same material and is free from dielectric regions, therefore it does not have sub-regions with coefficients of thermal expansion different from each other, resulting in reduction of undesired mechanical stresses inside the membrane 55. Furthermore, the variable capacitor formed by the membrane 55 and the lower electrode region 12 is substantially free from fixed-capacitance parasitic capacitors.

Finally, it is clear that modifications and variations may be made to the MEMS transducer and the related manufacturing process previously described and illustrated, without departing from the scope of the present invention, as defined in the attached claims.

For example, the conductive coupling region 68, instead of contacting the annular region 52 of the third upper conductive structure 50, may extend on an insulating region (not shown; for example, of silicon nitride), which is interposed between the annular region 52 and the conductive coupling region 68. In this case, the conductive coupling region 68 is electrically decoupled from the ground contact region 18.

As previously mentioned, the buried cavity 3 may be absent, in which case the trench 11 stops at the front surface S₂ of the semiconductor body 2, as shown in Figure 24.

The third upper conductive structure 50 may be formed by amorphous silicon, rather than polysilicon. In this case, the third conductive layer 450 shown in Figure 21 is formed for example by PECVD deposition of amorphous silicon.

The stopping region 6 may be formed by a material other than aluminum oxide, such as for example silicon nitride.

As to the manufacturing process, it may comprise annealings not explicitly mentioned above. The order of some steps may vary with respect to what has been described.

For example, the first conductive layer 430 may be formed by epitaxial polysilicon.

Furthermore, in general, all the previously mentioned polysilicon regions may have arbitrary doping levels and types, for example obtained by corresponding implants.

The formation of the front dielectric layer 420 and of the protection structures SX may also occur in a different manner than what has been described with reference to Figures 13-15. For example, the front dielectric layer may be formed with a single deposition; subsequently, the third openings W3 may be formed by selectively etching the front dielectric layer.

## Claims

1. A MEMS pressure transducer (1) comprising:
- a semiconductor body (2);
- a lower dielectric region (4,6), arranged above the semiconductor body (2);
- a fixed electrode region (12) and a lower anchoring region (14), which are formed by conductive material, are arranged on the lower dielectric region (4,6) and are laterally separated from each other;
- a membrane (55) of conductive material, which is suspended above the fixed electrode region (12), so as to delimit a cavity (39) upwardly, the fixed electrode region (12) facing the cavity, the membrane (55) being deformable as a function of pressure and forming a variable capacitor together with the fixed electrode region (12); and
- an upper anchoring region (37") of conductive material, which laterally delimits the cavity (39) and is interposed, in direct contact, between the membrane (55) and the lower anchoring region (14);
wherein the upper anchoring region (37") laterally delimits a lateral opening (A*) of the cavity (39),
said MEMS transducer (1) further comprising an upper dielectric region (20), which is arranged above the lower dielectric region (4,6) and laterally and externally surrounds the upper anchoring region (37"), so as to close the lateral opening (A*),
said cavity (39) being hermetically closed;
said transducer further comprising a first conductive region (36), which forms a part (37') of the membrane (55) and the upper anchoring region (37"); and wherein said part (37') of the membrane (55) is traversed by a number of holes (38) facing the cavity (39) and is impermeable to gases, with the exception of the holes (38);
said transducer (1) being **characterized in that** it further comprises:
- a second conductive region (46), which is permeable to gases and extends on the first conductive region (36) and inside the holes (38), so as to face the cavity (39); and
- a third conductive region (56), which is impermeable to gases and extends on the second conductive region (46);
and wherein the second and third conductive regions (46,56) form corresponding parts of the membrane (55).

2. The transducer according to claim 1, wherein the third conductive region (56) is formed by polysilicon or amorphous silicon.

3. The transducer according to claim 1 or 2, wherein the second conductive region (46) is formed by permeable polysilicon.

4. The transducer according to any of the preceding claims, wherein the first conductive region (36) is formed by polysilicon.

5. The transducer according to any of the preceding claims, wherein the lower dielectric region (4,6) and the upper dielectric region (20) form a dielectric support structure (100), said cavity (39) extending inside the dielectric support structure (100), the first, the second and the third conductive regions (36,46,56) overlying part of the dielectric support structure (100); said MEMS transducer (1) further comprising a passivation region (69) impermeable to humidity, which laterally coats part of the dielectric support structure (100) and coats upwardly portions of the dielectric support structure (100) left exposed by the first, the second and the third conductive regions (36,46,56).

6. The transducer according to any of the preceding claims, wherein the lower dielectric region (4,6) and the upper dielectric region (20) form a dielectric support structure (100), said cavity (39) extending inside the dielectric support structure (100), the first, the second and the third conductive regions (36,46,56) overlying part of the dielectric support structure (100); said MEMS transducer (1) further comprising a lower barrier structure (80), which extends through the lower dielectric region (4,6) and contacts the semiconductor body (2), and an upper barrier structure (160), which is laterally spaced from the membrane (55) and extends in part above the upper dielectric region (20) and in part through the upper dielectric region (20), so as to contact the lower barrier structure (80), the lower barrier structure (80) and the upper barrier structure (160) being of conductive material, being impermeable to humidity and laterally surrounding part of the dielectric support structure (100); and wherein the upper barrier structure (160) and the first, the second and the third conductive regions (36,46,56) leave exposed portions of the dielectric support structure (100), the MEMS transducer (1) further comprising a passivation region (69) impermeable to humidity, which coats upwardly the portions of the dielectric support structure (100) left exposed by the upper barrier structure (160) and the first, the second and the third conductive regions (36,46,56).

7. The transducer according to any of the preceding claims, wherein the semiconductor body (2) houses a buried cavity (3), which is upwardly delimited by a suspended portion (9') of the semiconductor body (2), which is laterally delimited by a trench (11) which traverses part of the semiconductor body (2) and communicates downwardly with the buried cavity (3), said suspended portion (9') extending cantilever from a fixed portion (9") of the semiconductor body (2); and wherein the cavity (39) is arranged above the suspended portion (9').

8. The transducer according to claim 7, wherein the lower dielectric region (4,6) and the upper dielectric region (20) form a dielectric support structure (100), said cavity (39) extending inside the dielectric support structure (100), the first, the second and the third conductive regions (36,46,56) overlying part of the dielectric support structure (100); said MEMS transducer (1) further comprising a barrier structure (260;360,380) of conductive and impermeable-to-humidity material, which extends in part above the upper dielectric region (20) and in part through the upper dielectric region (20) and through the lower dielectric region (4,6), up to contacting the semiconductor body (2), said barrier structure (260;360,380) laterally surrounding the dielectric support structure (100) and being traversed by the trench (11).

9. The transducer according to any of the preceding claims, wherein the lower dielectric region (4,6) comprises a stopping region (6) of a material chosen from aluminum oxide and silicon nitride; and wherein the fixed electrode region (12) and the lower anchoring region (14) extend over the stopping region (6), in direct contact; said MEMS transducer (1) further comprising a covering region (16), which is made of the same material as the fixed electrode region (12) and the lower anchoring region (14), extends on the stopping region (6), so as to face the cavity (39), and is interposed between the fixed electrode region (12) and the lower anchoring region (14), wherefrom it is laterally separated.

10. The transducer according to any of the preceding claims, further comprising a cap (70), which is mechanically coupled to the semiconductor body (2) so as to form a chamber (75), which houses the membrane (55); and wherein the cavity (39) is fluidically insulated from the chamber (75); and wherein the cap (70) has at least one respective hole (77).

11. A process for manufacturing a MEMS pressure transducer (1), comprising:
- forming a lower dielectric region (4,6) above a semiconductor body (2);
- on the lower dielectric region (4,6), forming a fixed electrode region (12) and a lower anchoring region (14) of conductive material, laterally separated from each other;
- forming a membrane (55) of conductive material, which is suspended above the fixed electrode region (12) and delimits a cavity (39) upwardly, the fixed electrode region (12) facing the cavity, the membrane (55) being deformable as a function of pressure and forming a variable capacitor together with the fixed electrode region (12); and
- forming an upper anchoring region (37") of conductive material, which laterally delimits the cavity (39) and is interposed, in direct contact, between the membrane (55) and the lower anchoring region (14);
said manufacturing process further comprising:
- forming a front dielectric layer (420) above the fixed electrode region (12) and the lower anchoring region (14); and successively
- selectively removing a portion of the front dielectric layer (420), so as to form an anchoring window (WA1) that traverses the front dielectric layer (420) and faces the lower anchoring region (14), said anchoring window (WA1) laterally delimiting a sacrificial portion (420') of the front dielectric layer (420); and successively
- forming a first conductive layer (430) on the front dielectric layer (420) and inside the anchoring window (WA1), said first conductive layer (430) being impermeable to gases; and successively
- forming a number of holes (38), which traverse a portion of the first conductive layer (430) that overlies the sacrificial portion (420');
wherein the upper anchoring region (37") laterally delimits a lateral opening (A*) of the cavity (39),
said manufacturing process further comprising forming an upper dielectric region (20), which is arranged above the lower dielectric region (4,6) and laterally and externally surrounds the upper anchoring region (37"), so as to close the lateral opening (A*) and hermetically close the cavity (39);
said manufacturing process being **characterized in that** it further comprises:
- after forming said holes (38), forming a second conductive layer (440) on the first conductive layer (430), said second conductive layer (440) being permeable to gases and extending inside the holes (38); and
- removing the sacrificial portion (420'), by flowing a gaseous chemical agent through the holes (38); and successively
- forming a third conductive layer (450), impermeable to gases, on the second conductive layer (440), so as to prevent the gas from flowing through the holes (38);
- selectively removing portions of the first, the second and the third conductive layer (430, 440, 450), in such a way that the membrane (55) is formed by corresponding residual portions of the first, the second and the third conductive layer (430, 440, 450), the residual portion of the first conductive layer (430) further forming the upper anchoring region (37").

12. The manufacturing process according to claim 11, wherein the third conductive layer (450) is formed by polysilicon or amorphous silicon; and wherein, if the third conductive layer (450) is formed by polysilicon, the manufacturing process comprises forming the third conductive layer (450) by epitaxial growth of polysilicon.

13. The manufacturing process according to claim 11 or 12, wherein the second conductive layer (440) is formed by permeable polysilicon.

14. The manufacturing process according to any of claims 11 to 13, wherein the first conductive layer (430) is formed by polysilicon.

15. The manufacturing process according to any of claims 11-14, wherein the lower dielectric region (4,6) and the upper dielectric region (20) form a dielectric support structure (100), said cavity (39) extending inside the dielectric support structure (100), the first, the second and the third conductive regions (36,46,56) overlying part of the dielectric support structure (100); said manufacturing process further comprising forming a passivation region (69) impermeable to humidity, which laterally coats part of the dielectric support structure (100) and coats upwardly portions of the dielectric support structure (100) left exposed by the first, the second and the third conductive regions (36,46,56).

16. The manufacturing process according to any of claims 11-14, wherein the lower dielectric region (4,6) and the upper dielectric region (20) form a dielectric support structure (100), said cavity (39) extending inside the dielectric support structure (100), the first, the second and the third conductive regions (36,46,56) overlying part of the dielectric support structure (100); said manufacturing process further comprising forming a lower barrier structure (80), which extends through the lower dielectric region (4,6) and contacts the semiconductor body (2), and an upper barrier structure (160), which is laterally spaced from the membrane (55) and extends in part above the upper dielectric region (20) and in part through the upper dielectric region (20), so as to contact the lower barrier structure (80), the lower barrier structure (80) and the upper barrier structure (160) being of conductive material, being impermeable to humidity and laterally surrounding part of the dielectric support structure (100); and wherein the upper barrier structure (160) and the first, the second and the third conductive regions (36,46,56) leave exposed portions of the dielectric support structure (100), said manufacturing process further comprising forming a passivation region (69) impermeable to humidity, which coats upwardly the portions of the dielectric support structure (100) left exposed by the upper barrier structure (160) and the first, the second and the third conductive regions (36,46, 56).

17. The manufacturing process according to any of claims 11-14, comprising forming, in the semiconductor body (2), a buried cavity (3), which is upwardly delimited by a suspended portion (9') of the semiconductor body (2), which is laterally delimited by a trench (11) which traverses part of the semiconductor body (2) and communicates downwardly with the buried cavity (3), said suspended portion (9') extending cantilever from a fixed portion (9") of the semiconductor body (2), said cavity (39) being arranged above the suspended portion (9'); and wherein the lower dielectric region (4,6) and the upper dielectric region (20) form a dielectric support structure (100), said cavity (39) extending inside the dielectric support structure (100), the first, the second and the third conductive regions (36,46,56) overlying part of the dielectric support structure (100); said manufacturing process further comprising forming a barrier structure (260;360,380) of conductive and impermeable-to-humidity material, which extends in part above the upper dielectric region (20) and in part through the upper dielectric region (20) and through the lower dielectric region (4,6), up to contacting the semiconductor body (2), said barrier structure (260;360,380) laterally surrounding the dielectric support structure (100) and being traversed by the trench (11).

## Patentansprüche

1. MEMS-Druckwandler (1), der Folgendes umfasst:
- einen Halbleiterkörper (2);
- einen unteren dielektrischen Bereich (4, 6), der oberhalb des Halbleiterkörpers (2) angeordnet ist;
- einen festen Elektrodenbereich (12) und einen unteren Verankerungsbereich (14), die aus leitfähigem Material gebildet sind, auf dem unteren dielektrischen Bereich (4, 6) angeordnet sind und seitlich voneinander getrennt sind;
- eine Membran (55) aus leitfähigem Material, die oberhalb des festen Elektrodenbereichs (12) aufgehängt ist, um einen Hohlraum (39) nach oben zu begrenzen, wobei der feste Elektrodenbereich (12) dem Hohlraum zugewandt ist, wobei die Membran (55) als Funktion des Drucks verformbar ist und zusammen mit dem festen Elektrodenbereich (12) einen variablen Kondensator bildet; und
- einen oberen Verankerungsbereich (37") aus leitfähigem Material, der den Hohlraum (39) seitlich begrenzt und in direktem Kontakt zwischen der Membran (55) und dem unteren Verankerungsbereich (14) eingefügt ist;
wobei der obere Verankerungsbereich (37") seitlich eine seitliche Öffnung (A*) des Hohlraums (39) begrenzt,
wobei der MEMS-Wandler (1) ferner einen oberen dielektrischen Bereich (20) umfasst, der oberhalb des unteren dielektrischen Bereichs (4, 6) angeordnet ist und den oberen Verankerungsbereich (37") seitlich und außen umgibt, so dass die seitliche Öffnung (A*) geschlossen ist, wobei der Hohlraum (39) hermetisch verschlossen ist;
wobei der Wandler ferner einen ersten leitfähigen Bereich (36) umfasst, der einen Teil (37') der Membran (55) und des oberen Verankerungsbereichs (37") bildet; und wobei der Teil (37') der Membran (55) von einer Anzahl von Löchern (38) durchquert wird, die dem Hohlraum (39) zugewandt sind, und mit Ausnahme der Löcher (38) gasundurchlässig ist;
wobei der Wandler (1) **dadurch gekennzeichnet ist, dass** er ferner Folgendes umfasst:
- einen zweiten leitfähigen Bereich (46), der gasdurchlässig ist und sich über den ersten leitfähigen Bereich (36) und innerhalb der Löcher (38) erstreckt, so dass er dem Hohlraum (39) zugewandt ist; und
- einen dritten leitfähigen Bereich (56), der gasundurchlässig ist und sich auf dem zweiten leitfähigen Bereich (46) erstreckt;
und wobei der zweite und der dritte leitfähige Bereiche (46, 56) entsprechende Teile der Membran (55) bilden.

2. Wandler nach Anspruch 1, wobei der dritte leitfähige Bereich (56) aus Polysilizium oder amorphem Silizium gebildet ist.

3. Wandler nach Anspruch 1 oder 2, wobei der zweite leitfähige Bereich (46) aus durchlässigem Polysilizium gebildet ist.

4. Wandler nach einem der vorhergehenden Ansprüche, wobei der erste leitfähige Bereich (36) aus Polysilizium gebildet ist.

5. Wandler nach einem der vorhergehenden Ansprüche, wobei der untere dielektrische Bereich (4, 6) und der obere dielektrische Bereich (20) eine dielektrische Stützstruktur (100) bilden, wobei sich der Hohlraum (39) innerhalb der dielektrischen Stützstruktur (100) erstreckt, wobei sich der erste, der zweite und der dritte leitfähige Bereich (36, 46, 56) einen Teil der dielektrischen Stützstruktur (100) überlagern; wobei der MEMS-Wandler (1) ferner einen feuchtigkeitsundurchlässigen Passivierungsbereich (69) umfasst, der seitlich einen Teil der dielektrischen Stützstruktur (100) bedeckt und nach oben hin Abschnitte der dielektrischen Stützstruktur (100) bedeckt, die durch den ersten, den zweiten und den dritten leitfähigen Bereich (36, 46, 56) freigelegt bleiben.

6. Wandler nach einem der vorhergehenden Ansprüche, wobei der untere dielektrische Bereich (4, 6) und der obere dielektrische Bereich (20) eine dielektrische Stützstruktur (100) bilden, wobei sich der Hohlraum (39) innerhalb der dielektrischen Stützstruktur (100) erstreckt, wobei der erste, der zweite und der dritte leitfähige Bereich (36, 46, 56) einen Teil der dielektrischen Stützstruktur (100) überlagern; wobei der MEMS-Wandler (1) ferner eine untere Barrierestruktur (80), die sich durch den unteren dielektrischen Bereich (4, 6) erstreckt und den Halbleiterkörper (2) berührt, und eine obere Barrierestruktur (160) umfasst, die seitlich von der Membran (55) beabstandet ist und sich teilweise über den oberen dielektrischen Bereich (20) und teilweise durch den oberen dielektrischen Bereich (20) erstreckt, so dass sie die untere Barrierestruktur (80) berührt, wobei die untere Barrierestruktur (80) und die obere Barrierestruktur (160) aus leitfähigem Material bestehen, feuchtigkeitsundurchlässig sind und einen seitlich einen Teil der dielektrischen Stützstruktur (100) umgeben; und wobei die obere Barrierestruktur (160) und der erste, der zweite und der dritte leitfähige Bereich (36, 46, 56) Abschnitte der dielektrischen Stützstruktur (100) freigelegt lassen, wobei der MEMS-Wandler (1) ferner einen feuchtigkeitsundurchlässigen Passivierungsbereich (69) umfasst, der nach oben hin die Abschnitte der dielektrischen Stützstruktur (100) bedeckt, die durch die obere Barrierestruktur (160) und den ersten, den zweiten und den dritten leitfähigen Bereich (36, 46, 56) freigelegt bleiben.

7. Wandler nach einem der vorhergehenden Ansprüche, wobei in dem Halbleiterkörper (2) ein vergrabener Hohlraum (3) untergebracht ist, der nach oben durch einen hängenden Abschnitt (9') des Halbleiterkörpers (2) begrenzt ist, der seitlich durch einen Graben (11) begrenzt ist, der einen Teil des Halbleiterkörpers (2) durchquert und nach unten mit dem vergrabenen Hohlraum (3) in Verbindung steht, wobei sich der hängende Abschnitt (9') freitragend von einem festen Abschnitt (9") des Halbleiterkörpers (2) erstreckt; und wobei der Hohlraum (39) oberhalb des hängenden Abschnitts (9') angeordnet ist.

8. Wandler nach Anspruch 7, wobei der untere dielektrische Bereich (4, 6) und der obere dielektrische Bereich (20) eine dielektrische Stützstruktur (100) bilden, wobei sich der Hohlraum (39) innerhalb der dielektrischen Stützstruktur (100) erstreckt, wobei der erste, der zweite und der dritte leitfähige Bereich (36, 46, 56) einen Teil der dielektrischen Stützstruktur (100) überlagern; wobei der MEMS-Wandler (1) ferner eine Barrierestruktur (260; 360, 380) aus leitfähigem und feuchtigkeitsundurchlässigem Material umfasst, die sich teilweise oberhalb des oberen dielektrischen Bereichs (20) und teilweise durch den oberen dielektrischen Bereich (20) und durch den unteren dielektrischen Bereich (4,6) erstreckt, bis sie den Halbleiterkörper (2) berührt, wobei die Barrierestruktur (260; 360, 380) seitlich die dielektrische Stützstruktur (100) umgibt und von dem Graben (11) durchquert wird.

9. Wandler nach einem der vorhergehenden Ansprüche, wobei der untere dielektrische Bereich (4, 6) einen Stoppbereich (6) aus einem Material umfasst, das aus Aluminiumoxid und Siliziumnitrid ausgewählt ist; und wobei sich der feste Elektrodenbereich (12) und der untere Verankerungsbereich (14) in direktem Kontakt über den Stoppbereich (6) erstrecken; wobei der MEMS-Wandler (1) ferner einen Abdeckbereich (16) umfasst, der aus demselben Material wie der feste Elektrodenbereich (12) und der untere Verankerungsbereich (14) besteht, sich auf dem Stoppbereich (6) erstreckt, so dass er dem Hohlraum (39) zugewandt ist, und zwischen dem festen Elektrodenbereich (12) und dem unteren Verankerungsbereich (14) eingefügt ist, von dem er seitlich getrennt ist.

10. Wandler nach einem der vorhergehenden Ansprüche, ferner umfassend eine Kappe (70), die mechanisch mit dem Halbleiterkörper (2) gekoppelt ist, um eine Kammer (75) zu bilden, in der die Membran (55) untergebracht ist; und wobei der Hohlraum (39) fluidisch von der Kammer (75) isoliert ist; und wobei die Kappe (70) mindestens ein jeweiliges Loch (77) aufweist.

11. Verfahren zum Herstellen eines MEMS-Druckwandlers (1), das Folgendes umfasst:
- Bilden eines unteren dielektrischen Bereichs (4, 6) oberhalb eines Halbleiterkörpers (2);
- auf dem unteren dielektrischen Bereich (4, 6), Bilden eines festen Elektrodenbereichs (12) und eines unteren Verankerungsbereichs (14) aus leitfähigem Material, die seitlich voneinander getrennt sind;
- Bilden einer Membran (55) aus leitfähigem Material, die über dem festen Elektrodenbereich (12) aufgehängt ist und einen Hohlraum (39) nach oben begrenzt, wobei der festen Elektrodenbereich (12) dem Hohlraum zugewandt ist, wobei die Membran (55) als Funktion des Drucks verformbar ist und zusammen mit dem festen Elektrodenbereich (12) einen variablen Kondensator bildet; und
- Bilden eines oberen Verankerungsbereichs (37") aus leitfähigem Material, der den Hohlraum (39) seitlich begrenzt und in direktem Kontakt zwischen der Membran (55) und dem unteren Verankerungsbereich (14) eingefügt ist;
wobei das Herstellungsverfahren ferner Folgendes umfasst:
- Bilden einer vorderen dielektrischen Schicht (420) oberhalb des festen Elektrodenbereichs (12) und des unteren Verankerungsbereichs (14); und nachfolgend
- selektives Entfernen eines Abschnitts der vorderen dielektrischen Schicht (420), so dass ein Verankerungsfenster (WA1) gebildet wird, das die vordere dielektrische Schicht (420) durchquert und dem unteren Verankerungsbereich (14) zugewandt ist, wobei das Verankerungsfenster (WA1) einen Opferabschnitt (420') der vorderen dielektrischen Schicht (420) seitlich begrenzt; und nachfolgend
- Bilden einer ersten leitfähigen Schicht (430) auf der vorderen dielektrischen Schicht (420) und innerhalb des Verankerungsfensters (WA1), wobei die erste leitfähige Schicht (430) gasundurchlässig ist; und nachfolgend
- Bilden einer Anzahl von Löchern (38), die einen Abschnitt der ersten leitfähigen Schicht (430) durchqueren, der den Opferabschnitt (420') überlagert;
wobei der obere Verankerungsbereich (37") seitlich eine seitliche Öffnung (A*) des Hohlraums (39) begrenzt, wobei das Herstellungsverfahren ferner das Bilden eines oberen dielektrischen Bereichs (20) umfasst, der oberhalb des unteren dielektrischen Bereichs (4, 6) angeordnet ist und den oberen Verankerungsbereich (37") seitlich und außen umgibt, um die seitliche Öffnung (A*) zu verschließen und den Hohlraum (39) hermetisch zu verschließen;
wobei das Herstellungsverfahren **dadurch gekennzeichnet ist, dass** es ferner Folgendes umfasst:
- nach dem Bilden der Löcher (38), Bilden einer zweiten leitfähigen Schicht (440) auf der ersten leitfähigen Schicht (430), wobei die zweite leitfähige Schicht (440) gasdurchlässig ist und sich innerhalb der Löcher (38) erstreckt; und
- Entfernen des Opferabschnitts (420 ' ), indem ein gasförmiges chemisches Mittel durch die Löcher (38) fließt; und nachfolgend
- Bilden einer dritten gasundurchlässigen, leitfähigen Schicht (450) auf der zweiten leitfähigen Schicht (440), um zu verhindern, dass das Gas durch die Löcher (38) fließt;
- selektives Entfernen von Abschnitten der ersten, der zweiten und der dritten leitfähigen Schicht (430, 440, 450), derart, dass die Membran (55) durch entsprechende Restabschnitte der ersten, der zweiten und der dritten leitfähigen Schicht (430, 440, 450) gebildet wird, wobei der Restabschnitt der ersten leitfähigen Schicht (430) ferner den oberen Verankerungsbereich (37") bildet.

12. Herstellungsverfahren nach Anspruch 11, wobei die dritte leitfähige Schicht (450) aus Polysilizium oder amorphem Silizium gebildet ist; und wobei, wenn die dritte leitfähige Schicht (450) aus Polysilizium gebildet ist, das Herstellungsverfahren das Bilden der dritten leitfähigen Schicht (450) durch epitaxiales Wachstum von Polysilizium umfasst.

13. Herstellungsverfahren nach Anspruch 11 oder 12, wobei die zweite leitfähige Schicht (440) aus durchlässigem Polysilizium gebildet ist.

14. Herstellungsverfahren nach einem der Ansprüche 11 bis 13, wobei die erste leitfähige Schicht (430) aus Polysilizium gebildet ist.

15. Herstellungsverfahren nach einem der Ansprüche 11-14, wobei der untere dielektrische Bereich (4, 6) und der obere dielektrische Bereich (20) eine dielektrische Stützstruktur (100) bilden, wobei sich der Hohlraum (39) innerhalb der dielektrischen Stützstruktur (100) erstreckt, wobei der erste, der zweite und der dritte leitfähige Bereich (36, 46, 56) einen Teil der dielektrischen Stützstruktur (100) überlagern; wobei das Herstellungsverfahren ferner das Bilden eines feuchtigkeitsundurchlässigen Passivierungsbereichs (69) umfasst, der seitlich einen Teil der dielektrischen Stützstruktur (100) bedeckt und nach oben hin Abschnitte der dielektrischen Stützstruktur (100) bedeckt, die durch den ersten, den zweiten und den dritten leitfähigen Bereich (36, 46, 56) freigelegt bleiben.

16. Herstellungsverfahren nach einem der Ansprüche 11-14, wobei der untere dielektrische Bereich (4, 6) und der obere dielektrische Bereich (20) eine dielektrische Stützstruktur (100) bilden, wobei sich der Hohlraum (39) innerhalb der dielektrischen Stützstruktur (100) erstreckt, wobei der erste, der zweite und der dritte leitfähige Bereich (36, 46, 56) einen Teil der dielektrischen Stützstruktur (100) überlagern; wobei das Herstellungsverfahren ferner das Bilden einer unteren Barrierestruktur (80), die sich durch den unteren dielektrischen Bereich (4,6) erstreckt und den Halbleiterkörper (2) berührt, und einer oberen Barrierestruktur (160) umfass, die seitlich von der Membran (55) beabstandet ist und sich teilweise über den oberen dielektrischen Bereich (20) und teilweise durch den oberen dielektrischen Bereich (20) erstreckt, so dass sie die untere Barrierestruktur (80) berührt, wobei die untere Barrierestruktur (80) und die obere Barrierestruktur (160) aus leitfähigem Material bestehen, feuchtigkeitsundurchlässig sind und einen Teil der dielektrischen Stützstruktur (100) seitlich umgeben; und wobei die obere Barrierestruktur (160) und der erste, der zweite und der dritten leitfähige Bereich (36, 46, 56) Abschnitte der dielektrischen Stützstruktur (100) freigelegt lassen, wobei das Herstellungsverfahren ferner das Bilden eines feuchtigkeitsundurchlässigen Passivierungsbereichs (69) umfasst, der nach oben hin die Abschnitte der dielektrischen Stützstruktur (100) bedeckt, die durch die obere Barrierestruktur (160) und den ersten, den zweiten und den dritten leitfähigen Bereich (36, 46, 56) freigelegt bleiben.

17. Herstellungsverfahren nach einem der Ansprüche 11-14, umfassend das Bilden eines vergrabenen Hohlraums (3) in dem Halbleiterkörper (2), der nach oben durch einen hängenden Abschnitt (9') des Halbleiterkörpers (2) begrenzt ist, der seitlich durch einen Graben (11) begrenzt ist, der einen Teil des Halbleiterkörpers (2) durchquert und nach unten mit dem vergrabenen Hohlraum (3) in Verbindung steht, wobei sich der hängende Abschnitt (9') freitragend von einem festen Abschnitt (9") des Halbleiterkörpers (2) erstreckt, wobei der Hohlraum (39) oberhalb des hängenden Abschnitts (9') angeordnet ist; und wobei der untere dielektrische Bereich (4, 6) und der obere dielektrische Bereich (20) eine dielektrische Stützstruktur (100) bilden, wobei sich der Hohlraum (39) innerhalb der dielektrischen Stützstruktur (100) erstreckt, wobei der erste, der zweite und der dritte leitfähige Bereich (36, 46, 56) einen Teil der dielektrischen Stützstruktur (100) überlagern; wobei das Herstellungsverfahren ferner das Bilden einer Barrierestruktur (260; 360, 380) aus leitfähigem und feuchtigkeitsundurchlässigem Material umfasst, die sich teilweise oberhalb des oberen dielektrischen Bereichs (20) und teilweise durch den oberen dielektrischen Bereich (20) und durch den unteren dielektrischen Bereich (4, 6) erstreckt, bis sie den Halbleiterkörper (2) berührt, wobei die Barrierestruktur (260; 360, 380) seitlich die dielektrische Stützstruktur (100) umgibt und von dem Graben (11) durchquert wird.

## Revendications

1. Transducteur (1) de pression MEMS comprenant :
- un corps semi-conducteur (2) ;
- une région diélectrique inférieure (4, 6), agencée au-dessus du corps semi-conducteur (2) ;
- une région d'électrode fixe (12) et une région d'ancrage inférieure (14), qui sont constituées d'un matériau conducteur, sont agencées sur la région diélectrique inférieure (4, 6), et sont séparées latéralement l'une de l'autre ;
- une membrane (55) en matériau conducteur, qui est suspendue au-dessus de la région d'électrode fixe (12), de façon à délimiter une cavité (39) vers le haut, la région d'électrode fixe (12) faisant face à la cavité, la membrane (55) étant déformable en fonction de la pression et formant un condensateur variable conjointement avec la région d'électrode fixe (12) ; et
- une région d'ancrage supérieure (37") en matériau conducteur, qui délimite latéralement la cavité (39) et est interposée, en contact direct, entre la membrane (55) et la région d'ancrage inférieure (14) ;
dans lequel la région d'ancrage supérieure (37") délimite latéralement une ouverture latérale (A*) de la cavité (39), ledit transducteur (1) MEMS comprenant en outre une région diélectrique supérieure (20), qui est agencée au-dessus de la région diélectrique inférieure (4, 6) et entoure latéralement et extérieurement la région d'ancrage supérieure (37"), de façon à fermer l'ouverture latérale (A*),
ladite cavité (39) étant fermée hermétiquement ;
ledit transducteur comprenant en outre une première région conductrice (36), qui forme une partie (37') de la membrane (55) et la région d'ancrage supérieure (37") ; et dans lequel ladite partie (37') de la membrane (55) est traversée par un certain nombre de trous (38) faisant face à la cavité (39) et est imperméable aux gaz, à l'exception des trous (38) ;
ledit transducteur (1) étant **caractérisé en ce qu'**il comprend en outre :
- une deuxième région conductrice (46), qui est perméable aux gaz et s'étend sur la première région conductrice (36) et à l'intérieur des trous (38), de façon à faire face à la cavité (39) ; et
- une troisième région conductrice (56), qui est imperméable aux gaz et s'étend sur la deuxième région conductrice (46) ;
et dans lequel les deuxième et troisième régions conductrices (46, 56) forment des parties correspondantes de la membrane (55).

2. Transducteur selon la revendication 1, dans lequel la troisième région conductrice (56) est constituée de polysilicium ou de silicium amorphe.

3. Transducteur selon la revendication 1 ou 2, dans lequel la deuxième région conductrice (46) est constituée de polysilicium perméable.

4. Transducteur selon l'une quelconque des revendications précédentes, dans lequel la première région conductrice (36) est constituée de polysilicium.

5. Transducteur selon l'une quelconque des revendications précédentes, dans lequel la région diélectrique inférieure (4, 6) et la région diélectrique supérieure (20) forment une structure de support diélectrique (100), ladite cavité (39) s'étendant à l'intérieur de la structure de support diélectrique (100), les première, deuxième et troisième régions conductrices (36, 46, 56) recouvrant une partie de la structure de support diélectrique (100) ; ledit transducteur (1) MEMS comprenant en outre une région de passivation (69) imperméable à l'humidité, qui couvre latéralement une partie de la structure de support diélectrique (100) et couvre vers le haut des portions de la structure de support diélectrique (100) laissées apparentes par les première, deuxième et troisième régions conductrices (36, 46, 56).

6. Transducteur selon l'une quelconque des revendications précédentes, dans lequel la région diélectrique inférieure (4, 6) et la région diélectrique supérieure (20) forment une structure de support diélectrique (100), ladite cavité (39) s'étendant à l'intérieur de la structure de support diélectrique (100), les première, deuxième et troisième régions conductrices (36, 46, 56) recouvrant une partie de la structure de support diélectrique (100) ; ledit transducteur (1) MEMS comprenant en outre une structure de barrière inférieure (80), qui s'étend à travers la région diélectrique inférieure (4, 6) et entre en contact avec le corps semi-conducteur (2), et une structure de barrière supérieure (160), qui est espacée latéralement de la membrane (55) et s'étend en partie au-dessus de la région diélectrique supérieure (20) et en partie à travers la région diélectrique supérieure (20), de façon à entrer en contact avec la structure de barrière inférieure (80), la structure de barrière inférieure (80) et la structure de barrière supérieure (160) étant en matériau conducteur, étant imperméables à l'humidité et entourant latéralement une partie de la structure de support diélectrique (100) ; et dans lequel la structure de barrière supérieure (160) et les première, deuxième et troisième régions conductrices (36, 46, 56) laissent apparentes des portions de la structure de support diélectrique (100), le transducteur (1) MEMS comprenant en outre une région de passivation (69) imperméable à l'humidité, qui couvre vers le haut les portions de la structure de support diélectrique (100) laissées apparentes par la structure de barrière supérieure (160) et les première, deuxième et troisième régions conductrices (36, 46, 56).

7. Transducteur selon l'une quelconque des revendications précédentes, dans lequel le corps semi-conducteur (2) abrite une cavité enfouie (3), qui est délimitée vers le haut par une portion suspendue (9') du corps semi-conducteur (2), qui est délimitée latéralement par une tranchée (11) qui traverse une partie du corps semi-conducteur (2) et communique vers le bas avec la cavité enfouie (3), ladite portion suspendue (9') s'étendant en porte-à-faux à partir d'une portion fixe (9") du corps semi-conducteur (2) ; et dans lequel la cavité (39) est agencée au-dessus de la portion suspendue (9').

8. Transducteur selon la revendication 7, dans lequel la région diélectrique inférieure (4, 6) et la région diélectrique supérieure (20) forment une structure de support diélectrique (100), ladite cavité (39) s'étendant à l'intérieur de la structure de support diélectrique (100), les première, deuxième et troisième régions conductrices (36, 46, 56) recouvrant une partie de la structure de support diélectrique (100) ; ledit transducteur (1) MEMS comprenant en outre une structure de barrière (260 ; 360, 380) en matériau conducteur et imperméable à l'humidité, qui s'étend en partie au-dessus de la région diélectrique supérieure (20) et en partie à travers la région diélectrique supérieure (20) et à travers la région diélectrique inférieure (4, 6), jusqu'à entrer en contact avec le corps semi-conducteur (2), ladite structure de barrière (260 ; 360, 380) entourant latéralement la structure de support diélectrique (100) et étant traversée par la tranchée (11).

9. Transducteur selon l'une quelconque des revendications précédentes, dans lequel la région diélectrique inférieure (4, 6) comprend une région d'arrêt (6) dans un matériau choisi parmi l'oxyde d'aluminium et le nitrure de silicium ; et dans lequel la région d'électrode fixe (12) et la région d'ancrage inférieure (14) s'étendent sur la région d'arrêt (6), en contact direct ; ledit transducteur (1) MEMS comprenant en outre une région de revêtement (16), qui est faite du même matériau que la région d'électrode fixe (12) et la région d'ancrage inférieure (14), s'étend sur la région d'arrêt (6), de façon à faire face à la cavité (39), et est interposée entre la région d'électrode fixe (12) et la région d'ancrage inférieure (14), desquelles elle est séparée latéralement.

10. Transducteur selon l'une quelconque des revendications précédentes, comprenant en outre un capuchon (70), qui est accouplé mécaniquement au corps semi-conducteur (2) de façon à former une chambre (75), qui abrite la membrane (55) ; et dans lequel la cavité (39) est isolée fluidiquement de la chambre (75) ; et dans lequel le capuchon (70) a au moins un trou (77) respectif.

11. Procédé pour fabriquer un transducteur (1) de pression MEMS, comprenant :
- la formation d'une région diélectrique inférieure (4, 6) au-dessus d'un corps semi-conducteur (2) ;
- sur la région diélectrique inférieure (4, 6), la formation d'une région d'électrode fixe (12) et d'une région d'ancrage inférieure (14) en matériau conducteur, séparées latéralement l'une de l'autre ;
- la formation d'une membrane (55) en matériau conducteur, qui est suspendue au-dessus de la région d'électrode fixe (12) et délimite une cavité (39) vers le haut, la région d'électrode fixe (12) faisant face à la cavité, la membrane (55) étant déformable en fonction de la pression et formant un condensateur variable conjointement avec la région d'électrode fixe (12) ; et
- la formation d'une région d'ancrage supérieure (37") en matériau conducteur, qui délimite latéralement la cavité (39) et est interposée, en contact direct, entre la membrane (55) et la région d'ancrage inférieure (14) ;
ledit procédé de fabrication comprenant en outre :
- la formation d'une couche diélectrique avant (420) au-dessus de la région d'électrode fixe (12) et de la région d'ancrage inférieure (14) ; et successivement
- le retrait de manière sélective d'une portion de la couche diélectrique avant (420), de façon à former une fenêtre d'ancrage (WA1) qui traverse la couche diélectrique avant (420) et fait face à la région d'ancrage inférieure (14), ladite fenêtre d'ancrage (WA1) délimitant latéralement une portion sacrificielle (420') de la couche diélectrique avant (420) ; et successivement
- la formation d'une première couche conductrice (430) sur la couche diélectrique avant (420) et à l'intérieur de la fenêtre d'ancrage (WA1), ladite première couche conductrice (430) étant imperméable aux gaz; et successivement
- la formation d'un certain nombre de trous (38), qui traversent une portion de la première couche conductrice (430) qui recouvre la portion sacrificielle (420') ;
dans lequel la région d'ancrage supérieure (37") délimite latéralement une ouverture latérale (A*) de la cavité (39), ledit procédé de fabrication comprenant en outre la formation d'une région diélectrique supérieure (20), qui est agencée au-dessus de la région diélectrique inférieure (4, 6) et entoure latéralement et extérieurement la région d'ancrage supérieure (37"), de façon à fermer l'ouverture latérale (A*) et fermer hermétiquement la cavité (39) ;
ledit procédé de fabrication étant **caractérisé en ce qu'**il comprend en outre :
- après la formation desdits trous (38), la formation d'une deuxième couche conductrice (440) sur la première couche conductrice (430), ladite deuxième couche conductrice (440) étant perméable aux gaz et s'étendant à l'intérieur des trous (38) ; et
- le retrait de la portion sacrificielle (420'), en faisant s'écouler un agent chimique gazeux à travers les trous (38) ; et successivement
- la formation d'une troisième couche conductrice (450), imperméable aux gaz, sur la deuxième couche conductrice (440), de façon à empêcher le gaz de s'écouler à travers les trous (38) ;
- le retrait de manière sélective de portions de la première, de la deuxième et de la troisième couche conductrice (430, 440, 450), de telle sorte que la membrane (55) soit constituée de portions résiduelles correspondantes de la première, de la deuxième et de la troisième couche conductrice (430, 440, 450), la portion résiduelle de la première couche conductrice (430) formant en outre la région d'ancrage supérieure (37").

12. Procédé de fabrication selon la revendication 11, dans lequel la troisième couche conductrice (450) est constituée de polysilicium ou de silicium amorphe ; et dans lequel, si la troisième couche conductrice (450) est constituée de polysilicium, le procédé de fabrication comprend la formation de la troisième couche conductrice (450) par croissance épitaxiale de polysilicium.

13. Procédé de fabrication selon la revendication 11 ou 12, dans lequel la deuxième couche conductrice (440) est constituée de polysilicium perméable.

14. Procédé de fabrication selon l'une quelconque des revendications 11 à 13, dans lequel la première couche conductrice (430) est constituée de polysilicium.

15. Procédé de fabrication selon l'une quelconque des revendications 11 à 14, dans lequel la région diélectrique inférieure (4, 6) et la région diélectrique supérieure (20) forment une structure de support diélectrique (100), ladite cavité (39) s'étendant à l'intérieur de la structure de support diélectrique (100), les première, deuxième et troisième régions conductrices (36, 46, 56) recouvrant une partie de la structure de support diélectrique (100) ; ledit procédé de fabrication comprenant en outre la formation d'une région de passivation (69) imperméable à l'humidité, qui couvre latéralement une partie de la structure de support diélectrique (100) et couvre vers le haut des portions de la structure de support diélectrique (100) laissées apparentes par les première, deuxième et troisième régions conductrices (36, 46, 56).

16. Procédé de fabrication selon l'une quelconque des revendications 11 à 14, dans lequel la région diélectrique inférieure (4, 6) et la région diélectrique supérieure (20) forment une structure de support diélectrique (100), ladite cavité (39) s'étendant à l'intérieur de la structure de support diélectrique (100), les première, deuxième et troisième régions conductrices (36, 46, 56) recouvrant une partie de la structure de support diélectrique (100) ; ledit procédé de fabrication comprenant en outre la formation d'une structure de barrière inférieure (80), qui s'étend à travers la région diélectrique inférieure (4, 6) et entre en contact avec le corps semi-conducteur (2), et d'une structure de barrière supérieure (160), qui est espacée latéralement de la membrane (55) et s'étend en partie au-dessus de la région diélectrique supérieure (20) et en partie à travers la région diélectrique supérieure (20), de façon à entrer en contact avec la structure de barrière inférieure (80), la structure de barrière inférieure (80) et la structure de barrière supérieure (160) étant en matériau conducteur, étant imperméables à l'humidité et entourant latéralement une partie de la structure de support diélectrique (100) ; et dans lequel la structure de barrière supérieure (160) et les première, deuxième et troisième régions conductrices (36, 46, 56) laissent apparentes des portions de la structure de support diélectrique (100), ledit procédé de fabrication comprenant en outre la formation d'une région de passivation (69) imperméable à l'humidité, qui couvre vers le haut les portions de la structure de support diélectrique (100) laissées apparentes par la structure de barrière supérieure (160) et les première, deuxième et troisième régions conductrices (36, 46, 56).

17. Procédé de fabrication selon l'une quelconque des revendications 11 à 14, comprenant la formation, dans le corps semi-conducteur (2), d'une cavité enfouie (3), qui est délimitée vers le haut par une portion suspendue (9') du corps semi-conducteur (2), qui est délimitée latéralement par une tranchée (11) qui traverse une partie du corps semi-conducteur (2) et communique vers le bas avec la cavité enfouie (3), ladite portion suspendue (9') s'étendant en porte-à-faux à partir d'une portion fixe (9") du corps semi-conducteur (2), ladite cavité (39) étant agencée au-dessus de la portion suspendue (9') ; et dans lequel la région diélectrique inférieure (4, 6) et la région diélectrique supérieure (20) forment une structure de support diélectrique (100), ladite cavité (39) s'étendant à l'intérieur de la structure de support diélectrique (100), les première, deuxième et troisième régions conductrices (36, 46, 56) recouvrant une partie de la structure de support diélectrique (100) ; ledit procédé de fabrication comprenant en outre la formation d'une structure de barrière (260 ; 360, 380) en matériau conducteur et imperméable à l'humidité, qui s'étend en partie au-dessus de la région diélectrique supérieure (20) et en partie à travers la région diélectrique supérieure (20) et à travers la région diélectrique inférieure (4, 6), jusqu'à entrer en contact avec le corps semi-conducteur (2), ladite structure de barrière (260 ; 360, 380) entourant latéralement la structure de support diélectrique (100) et étant traversée par la tranchée (11).
